# EUROPEAN PATENT APPLICATION

(11) **EP 4 773 186 A1**
(43) Date of publication of application: **08.07.2026**
(21) Application number: 24877644.5
(22) Date of filing: 11.10.2024
(51) Int. Cl.: H01L 25/075, H10H 20/813, H10H 20/831, H10H 20/818, H10H 20/814, H10H 20/851, H10H 20/857, H10H 20/812, H10H 29/01, G09F 9/30

(54) **DISPLAY DEVICE**

(30) Priority: 13.10.2023 KR 20230137031
(71) Applicant: Samsung Display Co., Ltd., Yongin-si, Gyeonggi-do 17113 (KR)
(72) Inventor: CHOI, Jin Woo, Yongin-si Gyeonggi-do 17113 (KR); LEE, Kang Young, Yongin-si Gyeonggi-do 17113 (KR); JEON, Hyung Il, Yongin-si Gyeonggi-do 17113 (KR); TAE, Chang Il, Yongin-si Gyeonggi-do 17113 (KR)
(74) Representative: Walaski, Jan Filip
(86) International application number: PCT/KR2024/096339
(87) International publication number: WO 2025/080109

(57) **Abstract**

A display device includes a plurality of first electrode pads respectively corresponding to emission areas which emit light of different colors, a second electrode pad disposed on a same layer as the plurality of first electrode pads, and a light-emitting element electrically connected to the plurality of first electrode pads and the second electrode pad, where the light-emitting element includes a first stack including a first n-type semiconductor layer, a first p-type semiconductor layer, and a first active layer therebetween, a second stack overlapping the first stack in a first emission area among the emission areas, and including a second n-type semiconductor layer, a second p-type semiconductor layer, and a second active layer therebetween, and a conductor electrically connecting the first n-type semiconductor layer of the first stack to the second n-type semiconductor layer of the second stack.

## Description

### Technical Field

One or more embodiments relate to a display device, for example, a flexible display device.

### Background Art

Along with the development of display devices that visually displays various electrical signals, various display devices having desired characteristics, such as thinness, light weight, low power consumption, and the like, have been introduced. As an example, flexible display devices that are foldable or rollable in a roll shape have been developed. Recently, research and development on display devices of various structures such as stretchable display devices capable of changing into various shapes have been actively carried out.

### Disclosure of Invention

### Technical Problem

One or more embodiments include a display device such as a flexible display device.

### Solution to Problem

According to one or more embodiments, a display device includes a plurality of first electrode pads respectively corresponding to emission areas which emit light of different colors, a second electrode pad disposed on a same layer as the plurality of first electrode pads, and a light-emitting element electrically connected to the plurality of first electrode pads and the second electrode pad, where the light-emitting element includes a first stack including a first n-type semiconductor layer, a first p-type semiconductor layer, and a first active layer between the first n-type semiconductor layer and the first p-type semiconductor layer, a second stack overlapping the first stack in a first emission area among the emission areas, and including a second n-type semiconductor layer, a second p-type semiconductor layer, and a second active layer between the second n-type semiconductor layer and the second p-type semiconductor layer, and a conductor electrically connecting the first n-type semiconductor layer of the first stack to the second n-type semiconductor layer of the second stack.

In an embodiment, the second active layer may emit green light.

In an embodiment, the first stack of the light-emitting element may extend to a second emission area different from the first emission area, and the first active layer of the first stack may include a first first active portion arranged in the first emission area, and a second first active portion separated from the first first active portion and arranged in the second emission area.

In an embodiment, the light-emitting element may further include a first porous semiconductor layer overlapping the first stack in the second emission area, and quantum dots disposed inside the first porous semiconductor layer.

In an embodiment, the quantum dots may convert light emitted from the second first active portion into light of a different color.

In an embodiment, the second first active portion may be configured to emit blue light.

In an embodiment, the display device may further include a reflective layer disposed on a lateral surface of the first porous semiconductor layer.

In an embodiment, the display device may further include a second porous semiconductor layer overlapping the first stack and the second stack in the first emission area.

In an embodiment, the second porous semiconductor layer may not include quantum dots.

In an embodiment, the first n-type semiconductor layer of the first stack may extend to overlap the second electrode pad, and the display device may further include an electrode disposed between the first n-type semiconductor layer and the second electrode pad, and electrically connecting the first n-type semiconductor layer to the second electrode pad.

According to one or more embodiments, a display device includes a plurality of first electrode pads respectively corresponding to a first emission area, a second emission area, and a third emission area, a second electrode pad arranged to be adjacent to the plurality of first electrode pads, and a light-emitting element electrically connected to the plurality of first electrode pads and the second electrode pad, where the light-emitting element includes a first stack including a first n-type semiconductor layer overlapping the plurality of first electrode pads, a first p-type semiconductor layer on the first n-type semiconductor layer, and a first active layer between the first n-type semiconductor layer and the first p-type semiconductor layer, a second stack overlapping the first stack in the first emission area, and including a second n-type semiconductor layer, a second p-type semiconductor layer, and a second active layer between the second n-type semiconductor layer and the second p-type semiconductor layer, and a conductor electrically connecting the first n-type semiconductor layer of the first stack to the second n-type semiconductor layer of the second stack, where the first active layer includes a first first active portion arranged in the first emission area, a second first active portion arranged in the second emission area, and a third first active portion arranged in the third emission area.

In an embodiment, the first first active portion may be separated from the second first active portion and
the third first active portion, the first first active portion may not emit light, and the second first active portion may emit blue light.

In an embodiment, the second active layer may emit green light.

In an embodiment, the light-emitting element may further include a first porous semiconductor layer overlapping the first stack in the second emission area, and quantum dots disposed inside the first porous semiconductor layer, where the quantum dots may convert light emitted from the second first active portion into light of a different color.

In an embodiment, the display device may further include a reflective layer disposed on a lateral surface of the first porous semiconductor layer.

In an embodiment, the first n-type semiconductor layer of the first stack may extend to overlap the second electrode pad, and the display device may further include an electrode disposed between first n-type semiconductor layer and the second electrode pad, and electrically connecting the first n-type semiconductor layer to the second electrode pad.

According to one or more embodiments, a display device including a display area and a non-display area outside the display area includes a first island portion arranged in the display area, a first bridge portion connecting the first island portion to another first island portion adjacent to the first island portion, a plurality of first electrode pads respectively arranged in emission areas disposed in the first island portion, a second electrode pad arranged in the first island portion and adjacent to the plurality of first electrode pads, and a light-emitting element electrically connected to the plurality of first electrode pads and the second electrode pad, where the light-emitting element includes a first stack including a first n-type semiconductor layer, a first p-type semiconductor layer, and a first active layer between the first n-type semiconductor layer and the first p-type semiconductor layer, a second stack overlapping the first stack in a first emission area among the emission areas, and including a second n-type semiconductor layer, a second p-type semiconductor layer, and a second active layer between the second n-type semiconductor layer and the second p-type semiconductor layer, and a conductor electrically connecting the first n-type semiconductor layer of the first stack to the second n-type semiconductor layer of the second stack.

In an embodiment, the first stack of the light-emitting element may extend to a second emission area different from the first emission area, and the first active layer of the first stack may include a first first active portion arranged in the first emission area, and a second first active portion separated from the first first active portion and arranged in the second emission area, where the first first active portion may not emit light, and the second first active portion may emit blue light.

In an embodiment, the second active layer may emit green light.

In an embodiment, the light-emitting element may further include a first porous semiconductor layer overlapping the first stack in the second emission area, and quantum dots disposed inside the first porous semiconductor layer.

In an embodiment, the quantum dots may convert light emitted from the second first active portion into light of a different color.

In an embodiment, the display device may further include a reflective layer disposed on a lateral surface of the first porous semiconductor layer.

In an embodiment, the display device may further include a second porous semiconductor layer overlapping the first stack and the second stack in the first emission area.

In an embodiment, the second porous semiconductor layer may not include quantum dots.

In an embodiment, the first n-type semiconductor layer of the first stack may extend to overlap the second electrode pad, and the display device may further include an electrode disposed between first n-type semiconductor layer and the second electrode pad, and electrically connecting the first n-type semiconductor layer to the second electrode pad.

### Advantageous Effects of Invention

According to an embodiment, a process of manufacturing a display device may be simplified by configuring a light-emitting element of a single chip shape, and a light emission efficiency in each emission area may be improved.

These effects are exemplary and the scope of the present invention is not limited by the above-described effects.

### Brief Description of Drawings

The above and other features of certain embodiments of the disclosure will be more apparent from the following description taken in conjunction with the accompanying drawings.
FIG. 1 is a schematic perspective view of a display device according to an embodiment.
FIGS. 2A and 2B are perspective views showing a state in which the display device of FIG. 1 is stretched in a first direction.
FIG. 2C is a perspective view showing a state in which the display device of FIG. 1 is stretched in a second direction.
FIG. 2D is a perspective view showing a state in which the display device of FIG. 1 is stretched in the first direction and the second direction.
FIG. 2E is a perspective view showing a state in which the display device of FIG. 1 is stretched in a third direction.
FIG. 3 is a schematic plan view of a display device according to an embodiment.
FIG. 4A is an enlarged plan view of a portion of the display device corresponding to a region IV of FIG. 3 according to an embodiment.
FIG. 4B is an enlarged plan view of a portion of the display device corresponding to the region IV of FIG. 3 according to an embodiment.
FIG. 4C is an enlarged plan view of a portion of the display device 1, corresponding to the region IV of FIG. 3 according to an embodiment.
FIG. 5 is a schematic cross-sectional view of a first island portion and a first bridge portion in a display area of a display device according to an embodiment.
FIGS. 6A to 6C are each equivalent circuit diagrams of a sub-pixel of a display device according to an embodiment.
FIGS. 7A and 7B are each schematic cross-sectional views of a light-emitting element of a display device according to an embodiment.
FIG. 8A is a schematic perspective view of the light-emitting element arranged in a first island portion of the display device according to an embodiment.
FIG. 8B is a schematic plan view of the light-emitting element arranged in a first island portion of the display device according to another embodiment.
FIG. 9 is a cross-sectional view of the light-emitting element shown in FIG. 8A, taken along line IX-IX' of FIG. 8A according to an embodiment.
FIG. 10 is a cross-sectional view of the light-emitting element shown in FIG. 8A, taken along line IX-IX' of FIG. 8A according to an embodiment.
FIG. 11 is a cross-sectional view of the light-emitting element shown in FIG. 8A, taken along line IX-IX' of FIG. 8A according to an embodiment.
FIGS. 12A to 12H are cross-sectional views showing a process of manufacturing a display element, according to an embodiment.
FIGS. 13A to 13G are each schematic perspective views of embodiments of an electronic apparatus including the display device according to an embodiment.

### Best Mode for Carrying out the Invention

According to one or more embodiments, a display device includes a plurality of first electrode pads respectively corresponding to emission areas which emit light of different colors, a second electrode pad disposed on a same layer as the plurality of first electrode pads, and a light-emitting element electrically connected to the plurality of first electrode pads and the second electrode pad, where the light-emitting element includes a first stack including a first n-type semiconductor layer, a first p-type semiconductor layer, and a first active layer between the first n-type semiconductor layer and the first p-type semiconductor layer, a second stack overlapping the first stack in a first emission area among the emission areas, and including a second n-type semiconductor layer, a second p-type semiconductor layer, and a second active layer between the second n-type semiconductor layer and the second p-type semiconductor layer, and a conductor electrically connecting the first n-type semiconductor layer of the first stack to the second n-type semiconductor layer of the second stack.

According to one or more embodiments, a display device includes a plurality of first electrode pads respectively corresponding to a first emission area, a second emission area, and a third emission area, a second electrode pad arranged to be adjacent to the plurality of first electrode pads, and a light-emitting element electrically connected to the plurality of first electrode pads and the second electrode pad, where the light-emitting element includes a first stack including a first n-type semiconductor layer overlapping the plurality of first electrode pads, a first p-type semiconductor layer on the first n-type semiconductor layer, and a first active layer between the first n-type semiconductor layer and the first p-type semiconductor layer, a second stack overlapping the first stack in the first emission area, and including a second n-type semiconductor layer, a second p-type semiconductor layer, and a second active layer between the second n-type semiconductor layer and the second p-type semiconductor layer, and a conductor electrically connecting the first n-type semiconductor layer of the first stack to the second n-type semiconductor layer of the second stack, where the first active layer includes a first first active portion arranged in the first emission area, a second first active portion arranged in the second emission area, and a third first active portion arranged in the third emission area.

According to one or more embodiments, a display device including a display area and a non-display area outside the display area includes a first island portion arranged in the display area, a first bridge portion connecting the first island portion to another first island portion adjacent to the first island portion, a plurality of first electrode pads respectively arranged in emission areas disposed in the first island portion, a second electrode pad arranged in the first island portion and adjacent to the plurality of first electrode pads, and a light-emitting element electrically connected to the plurality of first electrode pads and the second electrode pad, where the light-emitting element includes a first stack including a first n-type semiconductor layer, a first p-type semiconductor layer, and a first active layer between the first n-type semiconductor layer and the first p-type semiconductor layer, a second stack overlapping the first stack in a first emission area among the emission areas, and including a second n-type semiconductor layer, a second p-type semiconductor layer, and a second active layer between the second n-type semiconductor layer and the second p-type semiconductor layer, and a conductor electrically connecting the first n-type semiconductor layer of the first stack to the second n-type semiconductor layer of the second stack.

### Mode for the Invention

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. F or example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. Throughout the disclosure, the expression "at least one of a, b or c" or "at least one selected from a, b and c" indicates only a, only b, only c, both a and b, both a and c, both b and c, all of a, b, and c, or variations thereof.

It will be understood that the terms "comprise," "comprising," "include" and/or "including" as used herein specify the presence of stated features or elements but do not preclude the addition of one or more other features or elements.

It will be further understood that, when a layer, region, or element is referred to as being "on" another layer, region, or element, it can be directly or indirectly on the other layer, region, or element. That is, for example, intervening layers, regions, or elements may be present.

Sizes of elements in the drawings may be exaggerated or reduced for convenience of explanation. As an example, the size and thickness of each element shown in the drawings are arbitrarily represented for convenience of description, and thus, the disclosure is not necessarily limited thereto.

In the case where a certain embodiment may be implemented differently, a specific process order may be performed in the order different from the described order. As an example, two processes successively described may be simultaneously performed substantially and performed in the opposite order.

It will be understood that when a layer, region, or element is referred to as being "connected" to another layer, region, or element, it may be "directly connected" to the other layer, region, or element or may be "indirectly connected" to the other layer, region, or element with another layer, region, or element located therebetween. For example, it will be understood that when a layer, region, or element is referred to as being "electrically connected" to another layer, region, or element, it may be "directly electrically connected" to the other layer, region, or element or may be "indirectly electrically connected" to the other layer, region, or element with another layer, region, or element interposed therebetween.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

The x-axis, the y-axis and the z-axis are not limited to three axes of the rectangular coordinate system, and may be interpreted in a broader sense. For example, the x-axis, the y-axis, and the z-axis may be perpendicular to one another, or may represent different orientations that are not perpendicular to one another.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

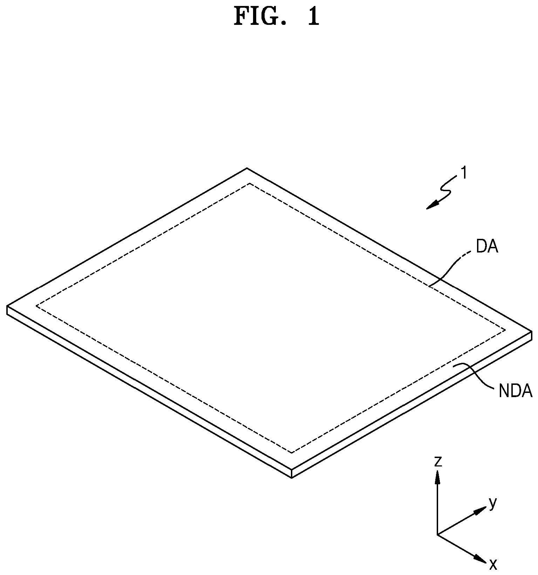

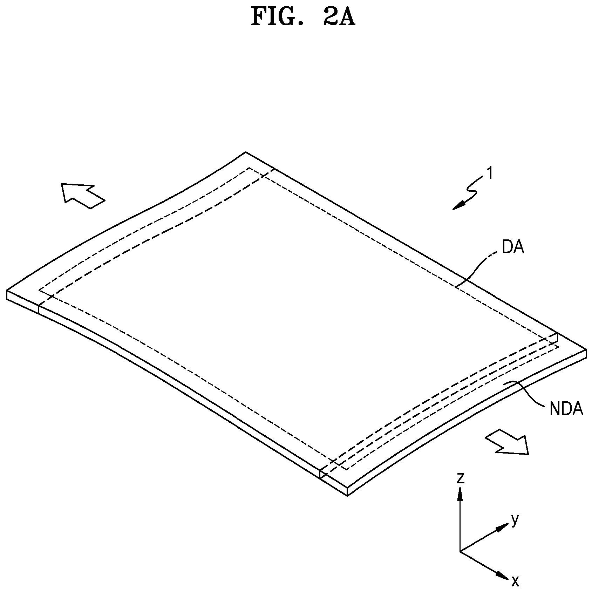

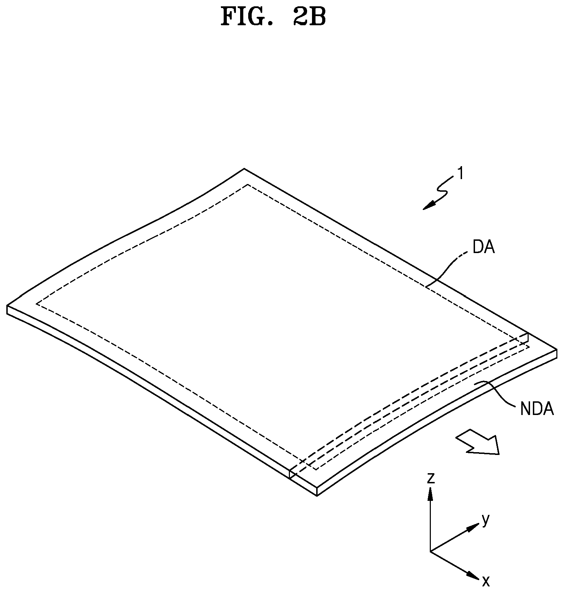

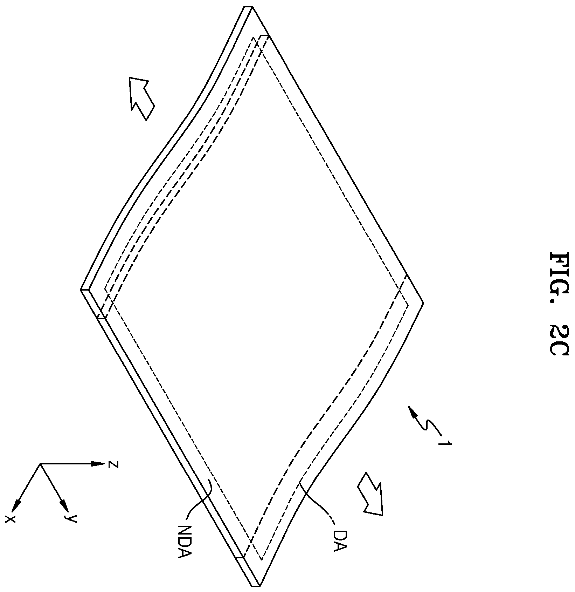

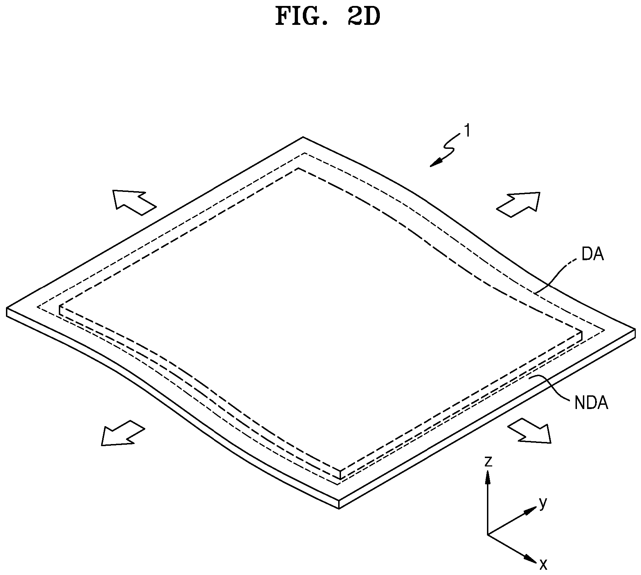

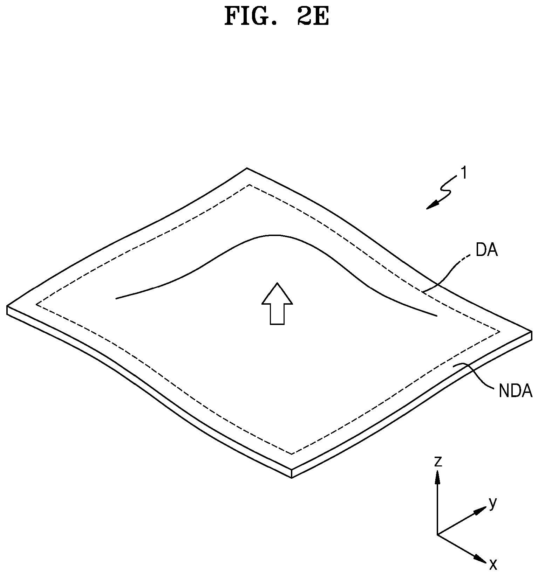

FIG. 1 is a schematic perspective view of a display device 1 according to an embodiment. FIGS. 2A and 2B are perspective views showing a state in which the display device 1 of FIG. 1 is stretched in a first direction. FIG. 2C is a perspective view showing a state in which the display device 1 of FIG. 1 is stretched in a second direction. FIG. 2D is a perspective view showing a state in which the display device 1 of FIG. 1 is stretched in the first direction and the second direction. FIG. 2E is a perspective view showing a state in which the display device 1 of FIG. 1 is stretched in a third direction.

Referring to FIG. 1, an embodiment of the display device 1 may include a display area DA and a non-display area NDA. The display area DA may include a plurality of pixels. The display device 1 may be configured to display preset images by using light emitted from the plurality of pixels. The non-display area NDA may be arranged outside the display area DA. In an embodiment, for example, the non-display area NDA is a region in which the pixels are not arranged and may surround the display area DA entirely.

The display device 1 may be stretched or shrunk in various directions. The display device 1 may be stretched in a first direction (e.g., an x direction and/or a -x direction) by an external force exerted by an external object or a user. In an embodiment, as shown in FIGS. 2A and 2B, the display area DA and/or the non-display area NDA of the display device 1 may be stretched in the first direction (e.g., the x direction and/or the -x direction). For example, as shown in FIG. 2A, the display area DA and/or the non-display area NDA may be stretched in the x direction and the -x direction, or be stretched in the x direction with one side of the display device 1 fixed as shown in FIG. 2B.

The display device 1 may be stretched in a second direction (e.g., a y direction and/or a -y direction) due to external force exerted by an external object or a user. In an embodiment, as shown in FIG. 2C, the display area DA and/or the non-display area NDA of the display device 1 may be stretched in the y direction and the -y direction. In another embodiment, the display area DA and/or the non-display area NDA may be stretched in the y direction or the -y direction with one side of the display device 1 fixed.

The display device 1 may be stretched in, for example, the first direction (e.g., the x direction and/or the -x direction) and the second direction (e.g., the y direction and/or the -y direction) due to external force exerted by an external object or a portion of a human body. In an embodiment, as shown in FIG. 2D, the display area DA and/or the non-display area NDA of the display device 1 may be stretched in a ±x direction and a ±y direction.

The display device 1 may be stretched in a third direction (e.g., a z direction or a -z direction) due to external force exerted by an external object or a portion of a human body. In an embodiment, as shown in FIG. 2E, a portion of the display device 1, for example, a partial region of the display area DA protrudes in the z direction. In another embodiment, a portion of the display device 1, for example, a partial region of the display area DA may protrude in a -z direction (or may be depressed in the z direction).

In an embodiment, as shown in FIGS. 2A to 2E, the display device 1 is stretched in the first direction, the second direction, and/or the third direction, but the embodiment is not limited thereto. In another embodiment, the display device 1 may be transformed into various shapes such as being bent or twisted along two or more axes.

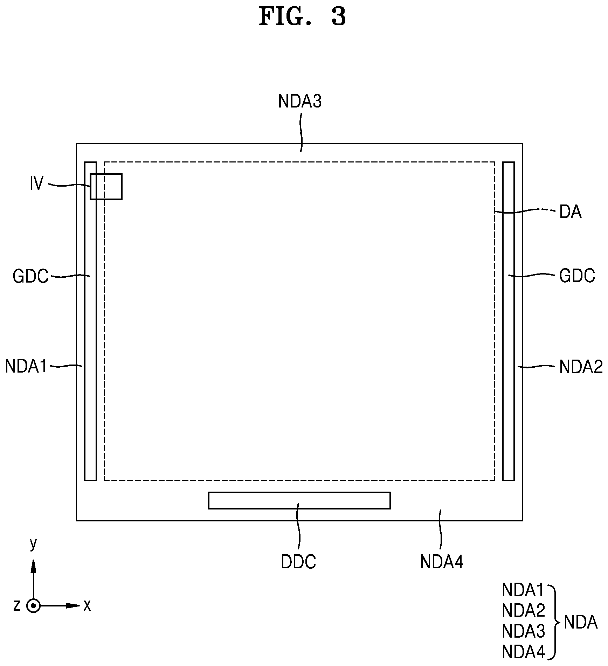

FIG. 3 is a schematic plan view of the display device 1 according to an embodiment.

In an embodiment, a plurality of pixels may be arranged in the display area DA of the display device 1. Each pixel may include sub-pixels configured to emit light of different colors. A light-emitting element corresponding to each sub-pixel may be arranged in the display area DA. A circuit may be arranged in the non-display area NDA around the display area DA, where the circuit is configured to provide electrical signals to light-emitting elements and transistors electrically connected to the light-emitting elements arranged in the display area DA. Gate driving circuits GDC may be respectively arranged in a first non-display area NDA1 and a second non-display area NDA2 respectively arranged on two opposite sides with the display area DA therebetween. The gate driving circuits GDC may include drivers configured to provide electrical signals to a gate electrode of each of the transistors electrically connected to the light-emitting elements. FIG. 3 illustrates an embodiment where the gate driving circuits GDC are respectively arranged in the first non-display area NDA1 and the second non-display area NDA2, but the embodiment is not limited thereto. In another embodiment, the gate driving circuit GDC may be arranged in one of the first non-display area NDA1 and the second non-display area NDA2.

A data driving circuit DDC may be arranged in a third non-display area NDA3 and/or a fourth non-display area NDA4 each connecting the first non-display area NDA1 to the second non-display area NDA2. In an embodiment, as shown in FIG. 3, the data driving circuit DDC is arranged in the fourth non-display area NDA4. In another embodiment, data driving circuits DDC may be respectively arranged in the third non-display area NDA3 and the fourth non-display area NDA4.

FIG. 3 illustrates an embodiment where the data driving circuit DDC is arranged in the fourth non-display area NDA4 of the display device 1, but the embodiment is not limited thereto. In another embodiment, the display device 1 may further include a flexible circuit board (not shown) electrically connected through a terminal portion (not shown) arranged in the fourth non-display area NDA4, and the data driving circuit DDC may be arranged on the flexible circuit board.

In an embodiment, an elongation of the non-display area NDA may be less than or equal to an elongation of the display area DA. In an embodiment, the elongation of the non-display area NDA may be different for each region thereof. In an embodiment, for example, the first non-display area NDA1, the second non-display area NDA2, and the third non-display area NDA3 may have a substantially same elongation, and an elongation of the fourth non-display area NDA4 may be less than the elongation of each of the first non-display area NDA1, the second non-display area NDA2, and the third non-display area NDA3.

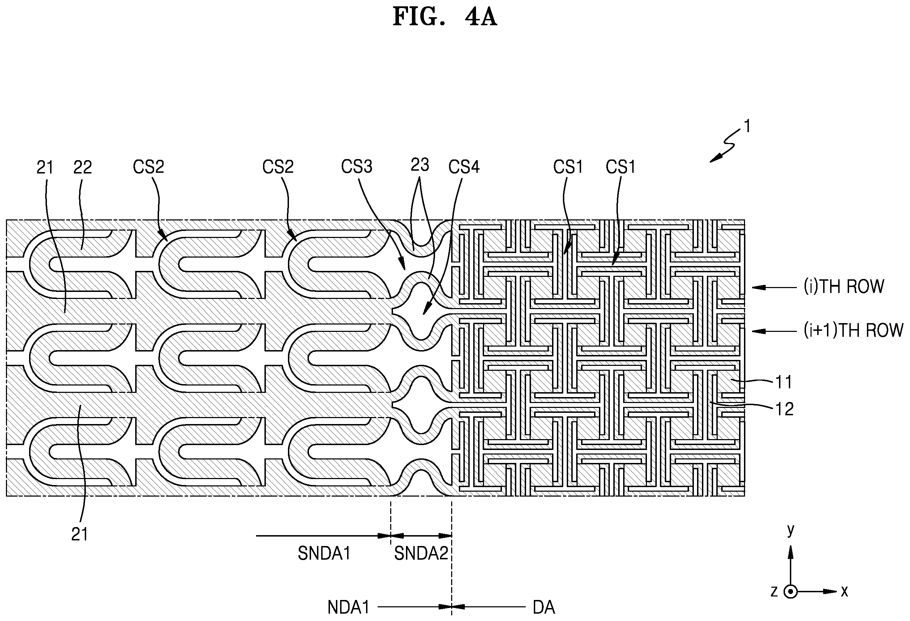

FIG. 4A is an enlarged plan view of a portion of the display device 1 corresponding to a region IV of FIG. 3 according to an embodiment.

Referring to FIG. 4A, an embodiment of the display device 1 may include first island portions 11 and first bridge portions 12, where the first island portions 11 are apart from each other in the first direction (e.g., the x direction or the -x direction) and the second direction (e.g., the y direction or the -y direction), and the first bridge portions 12 connect adjacent first island portions 11.

Each first island portion 11 may be connected to a plurality of first bridge portions 12. In an embodiment, for example, each first island portion 11 may be connected to four first bridge portions 12. Two first bridge portions 12 may be respectively arranged on two opposite sides of the first island portion 11 in the first direction (e.g., the x direction or the -x direction), and the remaining two first bridge portions 12 may be respectively arranged on two opposite sides of the first island portion 11 in the second direction (e.g., the y direction or the -y direction). In an embodiment, four first bridge portions 12 may be respectively connected to four sides of the first island portion 11. Each of the four first bridge portions 12 may be adjacent to the respective corners of the first island portion 11.

The first bridge portions 12 may be apart from each other by a first opening CS1 arranged between the first bridge portions 12. In an embodiment, the first openings CS1 having an approximate H shape (or an H-like shape) in the first direction (e.g., the x direction or the -x direction) and the second direction (e.g., the y direction or the -y direction), and the first openings CS1 having an approximate I shape (or an I-like shape), which is rotated by 90° from the H shape, may be repeatedly and alternately defined or arranged. Two opposite ends of each first bridge portion 12 may be respectively connected to adjacent first island portions 11, and one side of each first bridge portion 12 may be apart from one side of an adjacent first island portion 11 and/or one side of another first island portion 11 by the first opening CS1.

In the non-display area, for example, the first non-display area NDA1 shown in FIG. 4A, the display device 1 may include second island portions 21 apart from each other and second bridge portions 22 connecting adjacent second island portions 21.

Each second island portion 21 may extend in the first direction (e.g., the x direction or the -x direction). The second island portions 21 may be apart from each other in the second direction (e.g., the y direction or the -y direction) crossing the first direction (e.g., the x direction or the -x direction). Each second island portion 21 may include drivers of the gate driving circuit GDC (see FIG. 2) described with reference to FIG. 3.

The second bridge portion 22 may have a serpentine shape. The length of the second bridge portion 22 may be greater than a shortest distance between adjacent second island portions 21 in the second direction (e.g., the y direction or the -y direction). In an embodiment, the second bridge portion 22 may have an approximate omega Ω shape convex in the first direction (e.g., the x direction or the -x direction). The second bridge portions 22 may be arranged between adjacent second island portions 21 and be apart from each other.

The second bridge portions 22 between adjacent second island portions 21 may be apart from each other by a second opening CS2. Between adjacent second island portions 21, the second openings CS2 and the second bridge portions 22 may be alternately arranged in the first direction (e.g., the x direction or the -x direction). The second openings CS2 may have a same shape as each other. Two opposite ends of each second bridge portion 22 may be respectively connected to adjacent second island portions 21, and one side of each second bridge portion 22 may be apart from one side of an adjacent second island portion 21 and/or one side of another second island portion 22 by the second opening CS2.

One second island portion 21 arranged in the first non-display area NDA1 may correspond to the first island portions 11 in a plurality of rows arranged in the display area DA. In an embodiment, for example, one second island portion 21 arranged in the first non-display area NDA1 may correspond to the first island portions 11 in an i-th row (i)TH ROW and the first island portions 11 in an (i+1)-th row (i+1)TH ROW in the display area DA (here, i is a positive number greater than 0). In an embodiment, as shown in FIG. 4A, one second island portion 21 corresponds to two rows of the first island portions 11, but the embodiment is not limited thereto. In another embodiment, one second island portion 21 arranged in the first non-display area NDA1 may correspond to n rows of the first island portions 11 arranged in the display area DA (here, n is a positive number greater than or equal to 3).

The non-display area, for example, the first non-display area NDA1 may include a first sub-non-display area SNDA1 in which the second island portions 21 and the second bridge portions 22 are arranged, and a second sub-non-display area SNDA2 between the first sub-non-display area SNDA1 and the display area DA. Third bridges 23 may be arranged in the second sub-non-display area SNDA2, where the third bridge portions 23 connects the display area DA to the first sub-non-display area SNDA1. One end of the third bridge portion 23 may be connected to the second island portion 21 and/or the second bridge portion 22, and an opposing other end of the third bridge portion 23 may be connected to the first island portion 11 and/or the first bridge portion 12.

The third bridge portion 23 may have a serpentine shape. In an embodiment, the shape of the third bridge 23 may be different from the shape of each of the first bridge portion 12 and the second bridge portion 22. In an embodiment, as shown in FIG. 4A, the third bridge portion 23 may have an approximate omega Ω shape convex in the second direction (e.g., the y direction or the -y direction). The third bridge portions 23 may have a structure that is symmetrical to each other, such that one of the adjacent third bridge portions 23 arranged in the second direction (for example, y-direction or -y-direction) is convex in the y-direction and the other is convex in the -y-direction. A structure in which third openings CS3 and fourth openings CS4 of different shapes are repeated may be provided between the third bridge portions 23. The width of the third bridge portion 23 may be different from the width of the first bridge portion 12 and the width of the second bridge portion 22. In an embodiment, the width of the third bridge portion 23 may be greater than the width of the first bridge portion 12 and less than the width of the second bridge portion 22.

In an embodiment, as shown in FIG. 4A, the second island portion 21 and the second bridge portion 22 in the non-display area NDA, for example, the first non-display area NDA1, respectively have shapes different from the shapes of the first island portion 11 and the first bridge portion 12 in the display area DA. In another embodiment, the second island portion 21 and the second bridge portion 22 in the non-display area NDA may have the same shapes as the first island portion 11 and the first bridge portion 12 in the display area DA.

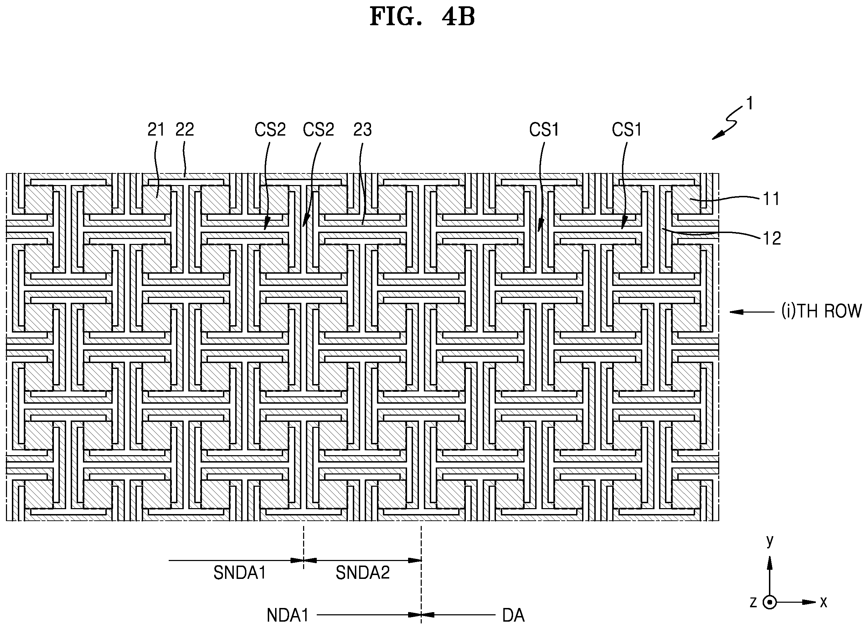

FIG. 4B is an enlarged plan view of a portion of the display device 1 corresponding to a region IV of FIG. 3 according to an embodiment.

Referring to FIG. 4B, an embodiment of the display device 1 includes the first island portions 11 apart from each other, and the first bridge portions 12 in the display area DA, where the first bridge portions 12 are apart from each other by the first opening CS1 and connects adjacent first island portions 11. The structure of the display area DA in FIG. 4B may be the same as the structure of the display area DA described above with reference to FIG. 4A.

In an embodiment, the display device 1 may include the second island portions 21 and the second bridge portions 22 arranged in the non-display area, for example, the first non-display area NDA1. In an embodiment, the second island portions 21 and the second bridge portions 22 may respectively have the substantially same shapes as the first island portions 11 and the first bridge portions 12.

The second island portions 21 may be apart from each other in the first direction (e.g., the x direction or the -x direction) and the second direction (for example, y-direction or -y-direction) in the non-display area, for example, the first non-display area NDA1. Each of the second bridge portions 22 may connect adjacent second island portions 21. The second bridge portions 22 may be apart from each other by the second opening CS2 arranged between the second bridge portions 22.

The second opening CS2 may have the substantially same shape as the first opening CS1. In an embodiment, for example, the second opening CS2 having an approximate H shape and the second opening CS2 having an approximate I shape may be alternately and repeatedly arranged in the non-display area, for example, the first non-display area NDA1. Two opposite ends of each second bridge portion 22 may be respectively connected to adjacent second island portions 21, and one side of each second bridge portion 22 may be apart from one side of an adjacent second island portion 21 and/or one side of another second island portion 22 by the second opening CS2.

Each second island portion 21 may be connected to four second bridge portions 22. Each second island portion 21 may include drivers of the gate driving circuit GDC (see FIG. 2) described with reference to FIG. 3.

The second island portions 21 arranged in one row in the first non-display area NDA1 may correspond to the first island portions 11 in one row arranged in the display area DA. In an embodiment, for example, the second island portions 21 arranged in the i-th row (i)TH ROW in the first direction (e.g., the x direction or the -x direction) in the first non-display area NDA1 may correspond to the first island portions 11 arranged in the same row, for example, an i-th row (i)TH ROW in the display area DA (here, i is a positive number greater than 0).

In an embodiment, the display device 1 may include the third bridge portions 23 arranged in the second sub-non-display area SNDA2, where the third bridge portions 23 connect the display area DA to the first sub-non-display area SNDA1. The non-display area, for example, the first non-display area NDA1 may include the first sub-non-display area SNDA1 in which the second island portions 21 and the second bridge portions 22 are arranged, and the second sub-non-display area SNDA2 including the third bridge portions 23 and arranged between the first sub-non-display area SNDA1 and the display area DA. The third bridge portion 23 may be substantially the same as the first bridge portion 12 and the second bridge portion 22. In an embodiment, for example, the width of the third bridge portion 23 may be the same as the width of the first bridge portion 12 and the width of the second bridge portion 22.

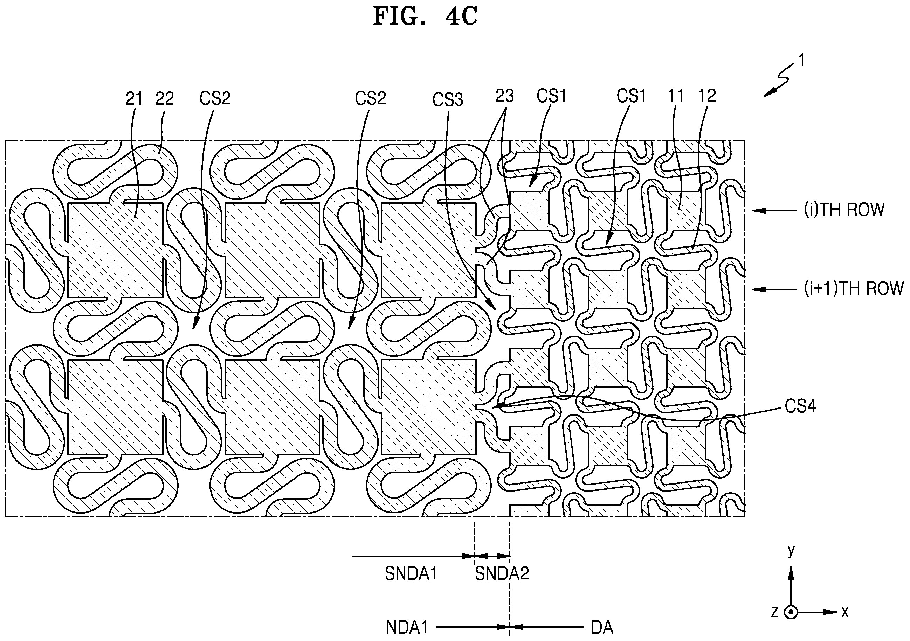

FIG. 4C is an enlarged plan view of a portion of the display device 1, corresponding to the region IV of FIG. 3 according to an embodiment.

Referring to FIG. 4C, an embodiment of the display device 1 may include first island portions 11 and first bridge portions 12, where the first island portions 11 are apart from each other in the first direction (e.g., the x direction or the -x direction) and the second direction (e.g., the y direction or the -y direction), and the first bridge portions 12 connect adjacent first island portions 11 in the display area DA.

The first bridge portions 12 may be apart from each other by a first opening CS1 arranged between the first bridge portions 12. The first bridge portion 12 may have a serpentine shape. In an embodiment, for example, as shown in FIG. 4C, the first bridge portion 12 may have an approximate shape of S or an S-like shape.

Each first island portion 11 may be connected to a plurality of first bridge portions 12. In an embodiment, for example, each first island portion 11 may be connected to four first bridge portions 12. Two first bridge portions 12 may be respectively arranged on two opposite sides of the first island portion 11 in the first direction (e.g., the x direction or the -x direction), and the remaining two first bridge portions 12 may be respectively arranged on two opposite sides of the first island portion 11 in the second direction (e.g., the y direction or the -y direction). The four first bridge portions 12 may be respectively connected to four sides of the first island portion 11. Each of the four first bridge portions 12 may be adjacent to the respective corners of the first island portion 11.

The display device 1 may include the second island portions 21 and the second bridge portions 22 connecting adjacent second island portions 21, where the second island portions 21 are apart from each other in the first direction (e.g., the x direction or the -x direction) and the second direction (e.g., the y direction or the -y direction) in the first non-display area NDA1 shown in FIG. 4C.

The second bridge portions 22 may be apart from each other by the second opening CS2 arranged between the second bridge portions 22. The second bridge portion 22 may have a serpentine shape. In an embodiment, for example, as shown in FIG. 4C, the second bridge portion 22 may have an approximate shape of S or an S-like shape. The size and/or width of the second bridge portion 22 may be different from the size and/or width of the first bridge portion 12. In an embodiment, for example, the size and/or width of the second bridge portion 22 may be greater than the size and/or width of the first bridge portion 12. A radius of curvature of a rounded portion of the second bridge portion 22 may be different from a radius of curvature of a rounded portion of the first bridge portion 12. In an embodiment, for example, the radius of curvature of a rounded portion of the second bridge portion 22 may be greater than the radius of curvature of a rounded portion of the first bridge portion 12.

Each second island portion 21 may be connected to a plurality of second bridge portions 22. Each second island portion 21 may be connected to four second bridge portions 22. Two second bridge portions 22 may be respectively arranged on two opposite sides of the second island portion 21 in the first direction (e.g., the x direction or the -x direction), and the remaining two second bridge portions 22 may be respectively arranged on two opposite sides of the second island portion 21 in the second direction (e.g., the y direction or the -y direction). In an embodiment, four second bridge portions 22 may be respectively connected to four sides of the second island portion 21. Each second bridge portion 22 may be connected to the central portion of each side of the second island portion 21.

The second island portions 21 in one row arranged in the first non-display area NDA1 may correspond to the first island portions 11 in a plurality of rows arranged in the display area DA. In an embodiment, for example, the second island portions 21 in one row arranged in the first non-display area NDA1 may correspond to the first island portions 11 in an i-th row (i)TH ROW and the first island portions 11 in an (i+1)-th row (i+1)TH ROW in the display area DA (here, i is a positive number greater than 0). In another embodiment, the second island portions 21 in one row may correspond to n rows of the first island portions 11 (here, n is a positive number greater than or equal to 3).

The non-display area, for example, the first non-display area NDA1 may include a first sub-non-display area SNDA1 in which the second island portions 21 and the second bridge portions 22 are arranged, and a second sub-non-display area SNDA2 between the first sub-non-display area SNDA1 and the display area DA. Third bridges 23 may be arranged in the second sub-non-display area SNDA2, where the third bridge portions 23 connects the display area DA to the first sub-non-display area SNDA1. One end of the third bridge portion 23 may be connected to the second island portion 21, and an opposing end of the third bridge portion 23 may be connected to the first island portion 11. In an embodiment, for example, one end of the third bridge portion 23 may be connected to the central portion of one side of the second island portion 21, and another end of the third bridge portion 23 may be connected to the central portion of one side of the first island portion 11.

The third bridge portion 23 may have a serpentine shape. In an embodiment, the shape of the third bridge 23 may be different from the shape of each of the first bridge portion 12 and the second bridge portion 22. The width of the third bridge portion 23 may be different from the width of the first bridge portion 12 and the width of the second bridge portion 22. The width of the third bridge portion 23 may be greater than the width of the first bridge portion 12 and less than the width of the second bridge portion 22. In the second direction (e.g., the y direction or the -y direction), the third openings CS3 and the fourth openings CS4 having different shapes may be alternately arranged between the third bridge portions 23.

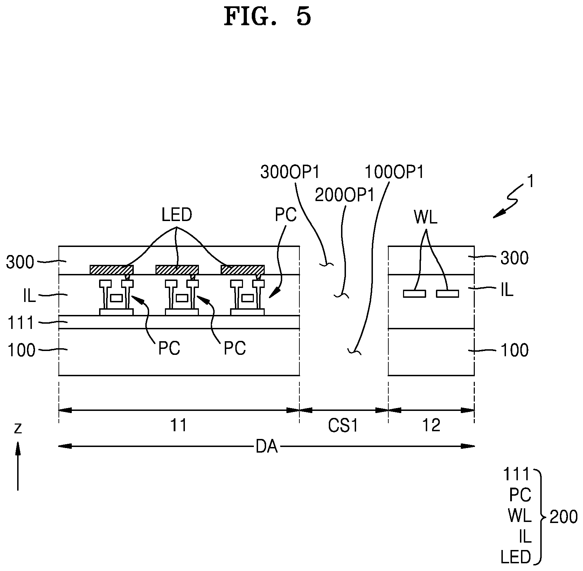

FIG. 5 is a schematic cross-sectional view of the first island portion 11 and the first bridge portion 12 arranged in the display area DA of the display device 1 according to an embodiment.

Referring to FIG. 5, in an embodiment, the first island portion 11 and the first bridge portion 12 arranged in the display area DA may be apart from each other with the first opening CS1 therebetween. The first island portion 11 may include light-emitting elements LED and a circuit, for example, a pixel driving circuit PC electrically connected to the light-emitting elements LED and configured to drive light-emitting elements. The bridge portion 12 may include a wiring WL electrically connected to the pixel driving circuits PC respectively arranged on adjacent first island portions 11.

In the first island portion 11, a buffer layer 111 including an inorganic insulating material may be disposed on a substrate 100, and the pixel driving circuit PC may be disposed on the buffer layer 111. An insulating layer IL including an inorganic insulating material and/or an organic insulating material may be disposed between the pixel driving circuit PC and the light-emitting element LED. The light-emitting element LED may be disposed on the insulating layer IL and electrically connected to the pixel driving circuit PC. The light-emitting elements LED may be configured to emit light of different colors from each other or emit light of a same color as each other. In an embodiment, the light-emitting elements LED may be configured to respectively emit red, green, and blue light. In an embodiment, the light-emitting elements LED may be configured to emit white light. In another embodiment, the light-emitting elements LED may be configured to respectively emit red, green, blue, and white light.

The substrate 100 may include polymer resin such as polyethersulfone, polyarylate, polyetherimide, polyethylene naphthalate, polyethylene terephthalate, polyphenylene sulfide, polyimide, polycarbonate, cellulose tri acetate, and cellulose acetate propionate. In an embodiment, the substrate 100 may include a single layer including the polymer resin. In another embodiment, the substrate 100 may have a multi-layered structure including a base layer and a barrier layer, where the base layer includes the above polymer resin and the barrier layer includes an inorganic insulating material. The substrate 100 including the polymer resin may be flexible, rollable, or bendable.

In an embodiment, as shown in FIG. 5, three pixel driving circuit portions PC are arranged in the first island portion 11, and three light-emitting elements LED are respectively connected to the pixel driving circuit portions PC, but the embodiment is not limited thereto. In another embodiment, the number of pixel driving circuit portions PC and the number of light-emitting elements LED arranged in the first island portion 11 may be one, two, four, or more.

An encapsulation layer 300 may be disposed on the light-emitting element LED and may protect the light-emitting element LED from external force and/or moisture transmission. The encapsulation layer 300 may include an inorganic encapsulation layer and/or an organic encapsulation layer. In an embodiment, the encapsulation layer 300 may have a structure in which an inorganic encapsulation layer including an inorganic insulating material, an organic encapsulation layer including an organic insulating material, and an inorganic encapsulation layer including an inorganic insulating material are stacked. In another embodiment, the encapsulation layer 300 may include an organic material such as resin. In an embodiment, the encapsulation layer 300 may include urethane epoxy acrylate. The encapsulation layer 300 may include a photosensitive material, for example, a photoresist.

In the first bridge portion 12, the insulating layer IL including an organic insulating material may be disposed on the substrate 100. In an embodiment, the first bridge portion 12, which is relatively transformed much when the display device 1 is stretched, may not include a layer including an inorganic insulating material that is prone to cracks.

In an embodiment, the substrate 100 corresponding to the first bridge portion 12 may have a same stack structure as the substrate 100 corresponding to the first island portion 11. In an embodiment, for example, the substrate 100 corresponding to the first bridge portion 12 and the substrate 100 corresponding to the first island portion 11 may include polymer resin layers simultaneously formed during the same process. In another embodiment, the substrate 100 corresponding to the first bridge portion 12 may have a stack structure different from the substrate 100 corresponding to the first island portion 11. In an embodiment, for example, the substrate 100 corresponding to the first bridge portion 12 may have a multi-layered structure including a base layer including polymer resin and a barrier layer including an inorganic insulating material, and the substrate 100 corresponding to the first bridge portion 12 may have a structure of a polymer resin layer without a layer including an inorganic insulating material.

In an embodiment, as described above, the wirings WL of the first bridge portion 12 may be signal lines (e.g., a gate line, a data line, and the like) configured to provide electrical signals to transistors included in the pixel driving circuit PC of the first island portion 11, or voltage lines (e.g., a driving voltage line, an initialization voltage line, and the like) configured to provide voltages. The encapsulation layer 300 may be disposed also on the first bridge portion 12. In another embodiment, the encapsulation layer 300 may not be present in the first bridge portion 12.

Referring to FIGS. 4A to 4C, and 5, the substrate 100 corresponding to the first island portion 11 and the substrate 100 corresponding to the first bridge portion 12 may be connected to each other. In other words, the plan views shown above in FIGS. 4A to 4C may be substantially the same as the plan view of the substrate 100 of FIG. 5. In other words, the substrate 100 may include a region corresponding to the first island portion 11 and a region corresponding to the first bridge portion 12, and may define an opening 1000P1 having a shape equal to the shape of the first opening CS1.

In an embodiment, the encapsulation layer 300 corresponding to the first island portion 11 and the encapsulation layer 300 corresponding to the first bridge portion 12 may be connected to each other. In an embodiment, for example, the plan views shown above in FIGS. 4A to 4C may be substantially the same as the plan view of the encapsulation layer 300. In such an embodiment, the encapsulation layer 300 may include a region corresponding to the first island portion 11, a region corresponding to the first bridge portion 12, and may define an opening 3000P1 having a shape equal to the shape of the first opening CS1.

A circuit-light-emitting element layer 200 between the substrate 100 and the encapsulation layer 300 may include the pixel driving circuit PC, the wiring WL, the insulating layer IL, and the light-emitting element LED. Similar to the substrate 100, the plan views shown above in FIGS. 4A to 4C may be substantially the same as the plan view of the circuit-light-emitting element layer 200. In other words, the circuit-light-emitting element layer 200 may include an opening 2000P1 having a shape equal to the first opening CS1.

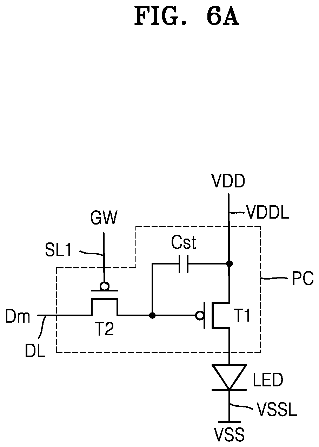

FIGS. 6A to 6C are each equivalent circuit diagrams of a sub-pixel of the display device 1 according to an embodiment.

Referring to FIG. 6A, in an embodiment of a sub-pixel, the light-emitting element LED corresponding to the sub-pixel may be electrically connected to the pixel driving circuit PC, and the pixel driving circuit PC may include a first transistor T1, a second transistor T2, and a storage capacitor Cst. The pixel driving circuit PC may be electrically connected to the signal lines and the voltage lines. The signal lines may include a gate line such as a first scan line SL1, and a data line DL. The voltage lines may include a first voltage line VDDL.

The second transistor T2 may be electrically connected to the first scan line SL1 and the data line DL. The first scan line SL1 may be configured to provide a first scan signal GW to a gate electrode of the second transistor T2. The second transistor T2 may be configured to transfer a data signal Dm to the first transistor T1 in response to a first scan signal GW input from the first scan line SL1, where the data signal Dm is input from the data line DL.

The storage capacitor Cst may be electrically connected to the second transistor T2 and a first voltage line VDDL and configured to store a voltage corresponding to a difference between a voltage transferred from the second transistor T2 and a first power voltage VDD supplied by the first voltage line VDDL.

The first transistor T1 is a driving transistor and may be configured to control a driving current flowing through the light-emitting element LED. The first transistor T1 may be connected to the first voltage line VDDL and the storage capacitor Cst. The first transistor T1 may be configured to control the driving current flowing from the first voltage line VDDL to the light-emitting element LED in response to a voltage value stored in the storage capacitor Cst. The light-emitting element LED may be configured to emit light having a preset brightness based on the driving current. A first electrode of the light-emitting element LED may be electrically connected to the first transistor T1, and a second electrode of the light-emitting element LED may be electrically connected to a second voltage line VSSL configured to supply a second power voltage VSS.

In an embodiment, as shown in FIG. 6A that the pixel driving circuit PC includes two transistors and one storage capacitor, but not being limited thereto. In another embodiment, the pixel driving circuit PC may include three or more transistors.

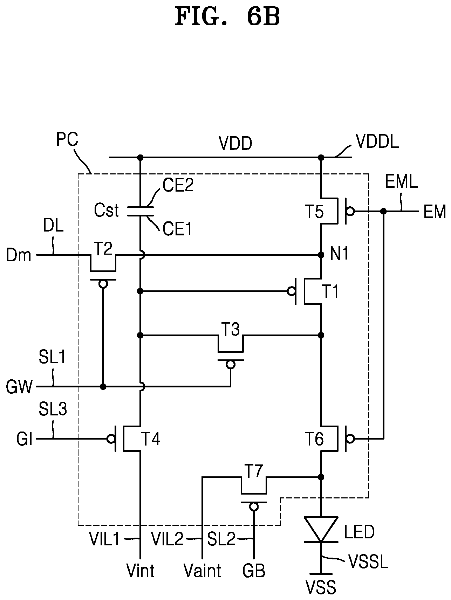

Referring to FIG. 6B, in an embodiment, the pixel driving circuit PC may include the first transistor T1, the second transistor T2, a third transistor T3, a fourth transistor T4, a fifth transistor T5, a sixth transistor T6, a seventh transistor T7, and the storage capacitor Cst.

The pixel driving circuit PC is electrically connected to the signal lines and the voltage lines. The signal lines may include the first scan line SL1, the second scan line SL2, the third scan line SL3, the gate line such as the emission control line EML, and the data line DL. The voltage lines may include first and second initialization voltage lines VIL1 and VIL2 and the first voltage line VDDL.

The first voltage line VDDL may be configured to transfer the first power voltage VDD to the first transistor T1. The first initialization voltage line VIL1 may be configured to transfer the first initialization voltage Vint to the pixel driving circuit PC, where the first initialization voltage Vint initializes the first transistor T1. The second initialization voltage line VIL2 may be configured to transfer the second initialization voltage Vaint to the pixel driving circuit PC, where the second initialization voltage Vaint initializes the first electrode of the light-emitting element LED.

The first transistor T1 may be electrically connected to the first voltage line VDDL through the fifth transistor T5, and electrically connected to the light-emitting element LED through the sixth transistor T6. The first transistor T1 serves as the driving transistor, receives a data signal Dm, and supplies the driving current to the light-emitting element LED according to a switching operation of the second transistor T2.

The second transistor T2 serves as a data-write transistor and is electrically connected to the first scan line SL1 and the data line DL. The second transistor T2 may be connected to the first voltage line VDDL through the fifth transistor T5. The second transistor T2 is turned on in response to a first scan signal GW transferred through the first scan line SL1, and performs a switching operation of transferring a data signal Dm to a first node N1, the data signal Dm being transferred through the data line DL.

The third transistor T3 is electrically connected to the first scan line SL1 and electrically connected to the light-emitting element LED through the sixth transistor T6. The third transistor T3 may be turned on in response to a first scan signal GW to diode-connect the first transistor T1, where the first scan signal GW is transferred through the first scan line SL1.

The fourth transistor T4 serves as a first initialization transistor and is electrically connected to the first initialization voltage line VIL1. The fourth transistor T4 may be turned on in response to a third scan signal GI to initialize a gate voltage of the first transistor T1 by transferring the initialization voltage Vint to the gate electrode of the first transistor T1, where the initialization voltage Vint is from the first initialization voltage line VIL1, and the third scan signal GI is transferred through the third scan line SL3. A third scan signal GI may correspond to a first scan signal of another pixel driving circuit arranged in a previous row of the relevant pixel driving circuit portion.

The fifth transistor T5 may be an operation control transistor, and the sixth transistor T6 may be an emission control transistor. The fifth transistor T5 and the sixth transistor T6 may be electrically connected to the emission control line EML, simultaneously turned on in response to an emission control signal EM transferred through the emission control line EML, and may form a current path such that the driving current flows in a direction from the first voltage line VDDL to the light-emitting element LED.

The seventh transistor T7 serves as a second initialization transistor and may be electrically connected to the second scan line SL2, the second initialization voltage line VIL2, and the sixth transistor T6. The seventh transistor T7 is turned on according to a second scan signal GB transferred through the second scan line SL2, and is configured to transfer the second initialization voltage Vaint from the second initialization voltage line VIL2 to the first electrode of the light-emitting element LED, thereby initializing the first electrode of the light-emitting element LED.

The storage capacitor Cst includes the first electrode CE1 and the second electrode CE2. The first electrode CE1 is electrically connected to the gate electrode of the first transistor T1, and the second electrode CE2 is electrically connected to the first voltage line VDDL. The storage capacitor Cst may maintain a voltage applied to the gate electrode of the first transistor T1 by storing and maintaining a voltage corresponding to a difference between voltages of two opposite ends of the gate electrode of the first transistor T1 and the first voltage line VDDL.

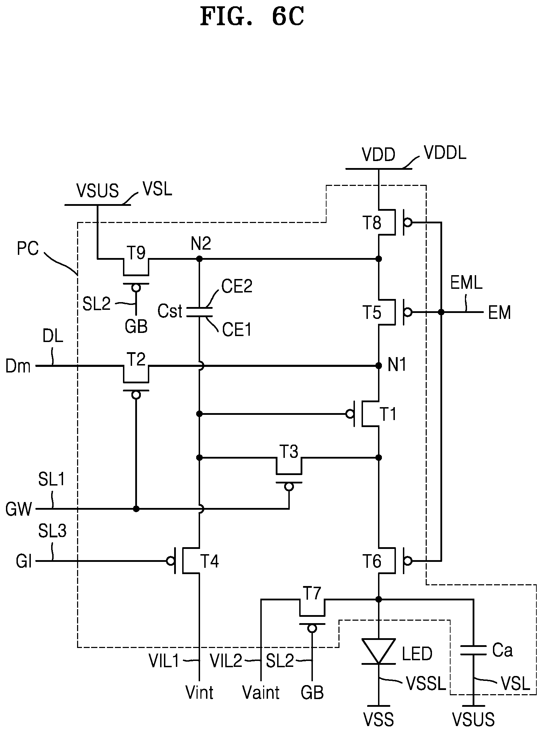

Referring to FIG. 6C, in an embodiment, the pixel driving circuit PC may include the first transistor T1, the second transistor T2, the third transistor T3, the fourth transistor T4, the fifth transistor T5, the sixth transistor T6, the seventh transistor T7, an eighth transistor T8, a ninth transistor T9, the storage capacitor Cst and an auxiliary capacitor Ca.

The pixel driving circuit PC is electrically connected to the signal lines and the voltage lines. The signal lines may include the first scan line SL1, the second scan line SL2, the third scan line SL3, the gate line such as the emission control line EML, and the data line DL. The voltage lines may include the first and second initialization voltage lines VIL1 and VIL2, a sustain voltage line VSL, and the first voltage line VDDL.

The first voltage line VDDL may be configured to transfer the first power voltage VDD to the first transistor T1. The first initialization voltage line VIL1 may be configured to transfer the first initialization voltage Vint to the pixel driving circuit PC, where the first initialization voltage Vint initializes the first transistor T1. The second initialization voltage line VIL2 may be configured to transfer the second initialization voltage Vaint to the pixel driving circuit PC, where the second initialization voltage Vaint initializes the first electrode of the light-emitting element LED. The sustain voltage line VSL may be configured to provide a sustain voltage VSUS to a second node N2, for example, the second electrode CE2 of the storage capacitor Cst during an initialization section and a data-write section.

The first transistor T1 may be electrically connected to the first voltage line VDDL through the fifth transistor T5 and the eighth transistor T8, and electrically connected to the light-emitting element LED through the sixth transistor T6. The first transistor T1 serves as the driving transistor, receives a data signal Dm, and may supply the driving current to the light-emitting element LED based on a switching operation of the second transistor T2.

The second transistor T2 is electrically connected to the first scan line SL1 and the data line DL and electrically connected to the first voltage line VDDL through the fifth transistor T5 and the eighth transistor T8. The second transistor T2 may be turned on according to a first scan signal GW transferred through the first scan line SL1 and may perform a switching operation of transferring a data signal Dm to the first node N1, where the data signal Dm is transferred through the data line DL.

The third transistor T3 is electrically connected to the first scan line SL1 and electrically connected to the light-emitting element LED through the sixth transistor T6. The third transistor T3 may be turned on in response to a first scan signal GW to compensate for a threshold voltage of the first transistor T1 by diode-connecting the first transistor T1, where the first scan signal GW is transferred through the first scan line SL1.

The fourth transistor T4 is electrically connected to the third scan line SL3 and the first initialization voltage line VIL1, turned on in response to a third scan signal GI transferred through the third scan line SL3, and initializes the voltage of the gate electrode of the first transistor T1 by transferring the initialization voltage Vint to the gate electrode of the first transistor T1, where the initialization voltage Vint is from the first initialization voltage line VIL1. A third scan signal GI may correspond to a first scan signal of another pixel driving circuit arranged in a previous row of the relevant pixel driving circuit portion.

The fifth transistor T5, the sixth transistor T6, and the eighth transistor T8 may be electrically connected to the emission control line EML, simultaneously turned on in response to an emission control signal EM transferred through the emission control line EML, and may form a current path such that the driving current flows in a direction from the first voltage line VDDL to the light-emitting element LED.

The seventh transistor T7 serves as a second initialization transistor and may be electrically connected to the second scan line SL2, the second initialization voltage line VIL2, and the sixth transistor T6. The seventh transistor T7 is turned on in response to a second scan signal GB transferred through the second scan line SL2, and is configured to transfer the second initialization voltage Vaint from the second initialization voltage line VIL2 to the first electrode of the light-emitting element LED, thereby initializing the first electrode of the light-emitting element LED.

The ninth transistor T9 may be electrically connected to the second scan line SL2, the second electrode CE2 of the storage capacitor Cst, and the sustain voltage line VSL. The ninth transistor T9 may be turned in response to a second scan signal GB transferred through the second scan line SL2 and configured to transfer the sustain voltage VSUS to the second node N2, for example, the second electrode CE2 of the storage capacitor Cst during the initialization section and the data-write section.

Each of the eighth transistor T8 and the ninth transistor T9 may be electrically connected to the second node N2, for example, the second electrode CE2 of the storage capacitor Cst. In an embodiment, during the initialization section and the data-write section, the eighth transistor T8 may be turned off and the ninth transistor T9 may be turned on, and during an emission section, the eighth transistor T8 may be turned on and the ninth transistor T9 may be turned off. Because, during the initialization section and the data-write section, the sustain voltage VSUS is transferred to the second node N2, uniformity in brightness (e.g., long range uniformity (LRU)) of the display device corresponding to a voltage drop of the first voltage line VDDL may be improved.

The storage capacitor Cst includes the first electrode CE1 and the second electrode CE2. The first electrode CE1 is electrically connected to the gate electrode of the first transistor T1, and the second electrode CE2 is electrically connected to the eighth transistor T8 and the ninth transistor T9.

The auxiliary capacitor Ca may be electrically connected to the sixth transistor T6, the sustain voltage line VSL, and the first electrode of the light-emitting element LED. While the seventh transistor T7 and the ninth transistor T9 are turned on, the auxiliary capacitor Ca stores and maintains a voltage corresponding to a voltage difference between the first electrode of the light-emitting element LED and the sustain voltage line VSL, thereby preventing a black brightness from rising when the sixth transistor T6 is turned off.

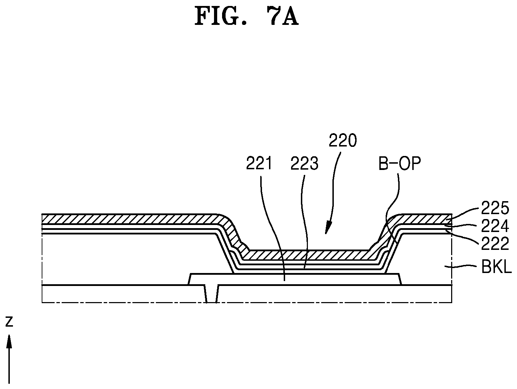

FIG. 7A is a schematic cross-sectional view of the light-emitting element of the display device according to an embodiment.

Referring to FIG. 7A, the light-emitting element according to an embodiment may include an organic light-emitting diode 220 including an organic material. The organic light-emitting diode 220 may include a first electrode 221 disposed on an insulating layer, a second electrode 225 facing the first electrode 221, and an emission layer 223 disposed between the first electrode 221 and the second electrode 225. A first functional layer 222 may be disposed between the first electrode 221 and the emission layer 223, and a second functional layer 224 may be disposed between the emission layer 223 and the second electrode 225.

The edges of the first electrode 221 may be covered by a bank layer BKL including an insulating material. The bank layer BKL may include an opening B-OP overlapping the central portion of the first electrode 221.

The first electrode 221 may include a conductive oxide such as indium tin oxide (ITO), indium zinc oxide (IZO), zinc oxide (ZnO), indium oxide (In₂O₃), indium gallium oxide (IGO), and/or aluminum zinc oxide (AZO). In another embodiment, the first electrode 221 may include a reflective layer including silver (Ag), magnesium (Mg), aluminum (Al), platinum (Pt), palladium (Pd), gold (Au), nickel (Ni), neodymium (Nd), iridium (Ir), chrome (Cr), or a compound thereof. In another embodiment, the first electrode 221 may further include a layer on/under the reflective layer, the layer including ITO, IZO, ZnO, AZO, or In₂O₃.

The emission layer 223 may include a polymer organic material or a low-molecular weight organic material emitting light having a preset color. The first functional layer 222 may include a hole transport layer (HTL) and/or a hole injection layer (HIL). The second functional layer 224 may include an electron transport layer (ETL) and/or an electron injection layer (EIL).

The second electrode 225 may include a conductive material having a low work function. In an embodiment, for example, the second electrode 225 may include a (semi-) transparent layer including silver (Ag), magnesium (Mg), aluminum (Al), platinum (Pt), palladium (Pd), gold (Au), nickel (Ni), neodymium (Nd), iridium (Ir), chrome (Cr), or an alloy thereof. Alternatively, the second electrode 225 may further include a layer on the (semi) transparent layer, where the layer includes ITO, IZO, ZnO, AZO, or In₂O₃.

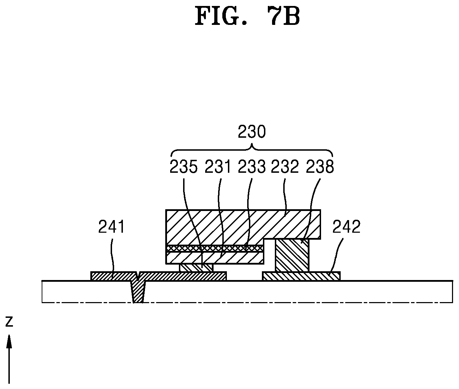

FIG. 7B is a schematic cross-sectional view of the light-emitting element of the display device according to an embodiment.

Referring to FIG. 7B, the light-emitting element according to an embodiment may include an inorganic light-emitting diode 230 including an inorganic material. The inorganic light-emitting diode 230 may include a first semiconductor layer 231, a second semiconductor layer 232, an intermediate layer 233 between the first semiconductor layer 231 and second semiconductor layer 232, a first electrode 235 electrically connected to the first semiconductor layer 231, and a second electrode 238 electrically connected to the second semiconductor layer 232. The first electrode 235 and the second electrode 238 of the inorganic light-emitting diode 230 may be respectively and electrically connected to a first electrode pad 241 and a second electrode pad 242 disposed on the same layer.

In an embodiment, the first semiconductor layer 231 may include a p-type semiconductor layer. The p-type semiconductor layer may include a semiconductor material with a composition formula of InₓAl_{y}Ga_{1-x-y}N (0≤x≤1, 0≤y≤1, 0≤x+y≤1), such as GaN, AIN, AlGaN, InGaN, InN, InAlGaN, AlInN, and/or the like, and may be doped with a p-type dopant such as Mg, Zn, Ca, Sr, Ba, and/or the like.

As an example, the second semiconductor layer 232 may include an n-type semiconductor layer. The n-type semiconductor layer may include a semiconductor material with a composition formula of InₓAl_{y}Ga_{1-x-y}N (0≤x≤1, 0≤y≤1, 0≤x+y≤1), such as GaN, AIN, AlGaN, InGaN, InN, InAlGaN, AlInN, and/or the like, and may be doped with n-type dopants such as Si, Ge, Sn, and/or the like.

The intermediate layer 233 is a region where electrons and holes recombine. As the electrons and holes recombine, the intermediate layer 233 transitions to a lower energy level and may generate light having a corresponding wavelength. In an embodiment, for example, the intermediate layer 233 may include a semiconductor material with a composition formula of InₓAl_{y}Ga_{1-x-y}N (0≤x≤1, 0≤y≤1, 0≤x+y≤1), and may be formed in a single quantum well structure or a multi quantum well structure (MQW). In addition, the intermediate layer 233 may include a quantum wire structure or a quantum dot structure.

In an embodiment, as described above, the first semiconductor layer 231 includes a p-type semiconductor layer, and the second semiconductor layer 232 includes an n-type semiconductor layer, but the embodiment is not limited thereto. In another embodiment, the first semiconductor layer 231 may include an n-type semiconductor layer, and the second semiconductor layer 232 may include a p-type semiconductor layer.

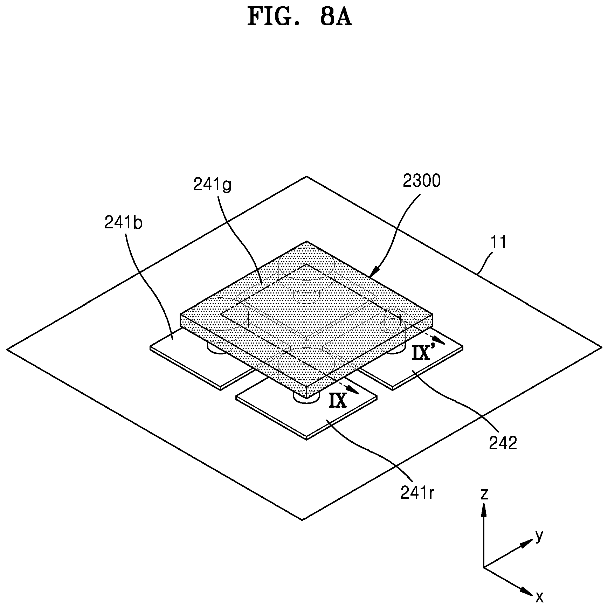

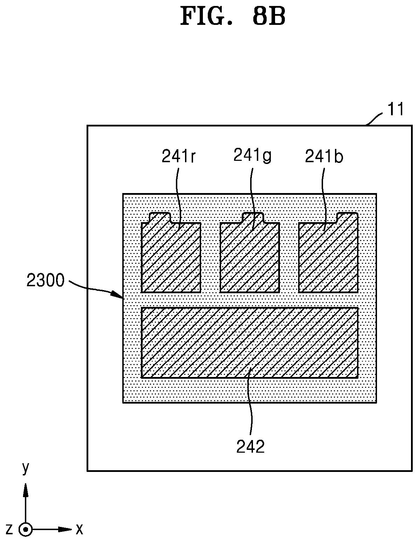

FIG. 8A is a schematic perspective view of the light-emitting element arranged in a first island portion of the display device according to an embodiment, and FIG. 8B is a schematic plan view of the light-emitting element arranged in a first island portion of the display device according to another embodiment.

Referring to FIG. 8A, in an embodiment, first electrode pads 241g, 241r, and 241b, and the second electrode pad 242 may be arranged to be apart from each other in the first island portion 11. The first electrode pads 241g, 241r, and 241b, and the second electrode pad 242 may be disposed in (or directly on) a same layer as each other. The first electrode pads 241g, 241r, and 241b may be located to correspond to emission areas configured to emit different light. In an embodiment, for example, a first first electrode pad 241g may be located to correspond to a green pixel, for example, an emission area configured to emit green light. A second first electrode pad 241r may be located to correspond to a red pixel, for example, an emission area configured to emit red light. A third first electrode pad 241b may be located to correspond to a blue pixel, for example, an emission area configured to emit blue light.

A light-emitting element 2300 may be disposed on the first electrode pads 241g, 241r, and 241b, and the second electrode pad 242. The light-emitting element 2300 may be a kind of single chip and be electrically connected to the first electrode pads 241g, 241r, and 241b, and the second electrode pad 242. In an embodiment, for example, a single light-emitting element 2300 including a stack structure configured to emit green, red, and blue light may be arranged to overlap the first electrode pads 241g, 241r, and 241b, and the second electrode pad 242.

In an embodiment, as shown in FIG. 8A, the first electrode pads 241g, 241r, and 241b, and the second electrode pad 242 are arranged in 2 rows by 2 columns, but the embodiment is not limited thereto. In another embodiment, as shown in FIG. 8B, the first electrode pads 241g, 241r, and 241b may be arranged in one direction, and the second electrode pad 242 may be arranged in a column different from a column of the first electrode pads 241g, 241r, and 241b. The size (or area) of the second electrode pad 242 may be substantially equal to (see FIG. 8A) or different from (see FIG. 8B) the size (or area) of each of the first electrode pads 241g, 241r, and 241b. In an embodiment, the size (or area) of the second electrode pad 242 may be greater than the size (or area) of each of the first electrode pads 241g, 241r, and 241b.

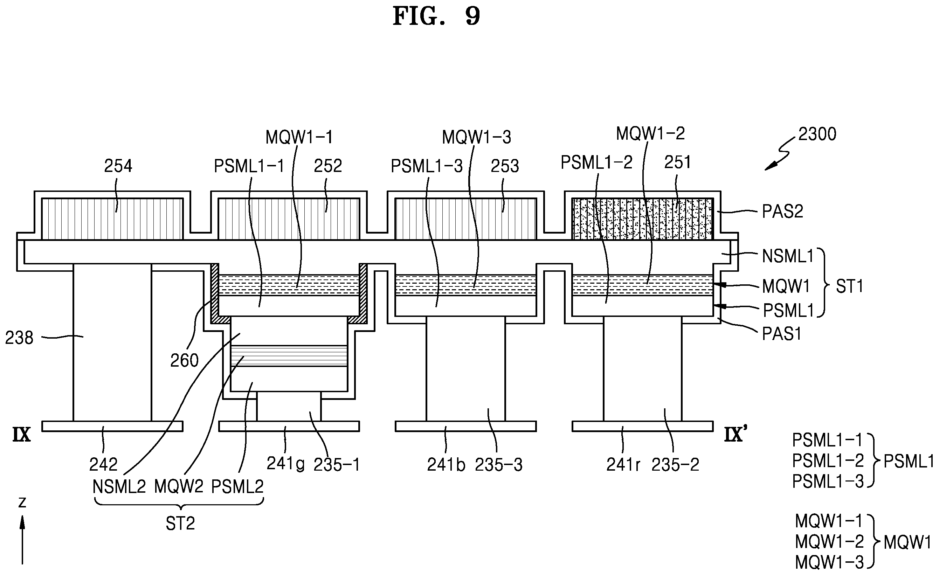

FIG. 9 is a cross-sectional view of the light-emitting element shown in FIG. 8A, taken along line IX-IX' of FIG. 8A according to an embodiment.

Referring to FIG. 9, an embodiment of the light-emitting element 2300 may include an overlapping structure of a first stack ST1 and a second stack ST2. The first stack ST1 may overlap the first electrode pads 241g, 241r, and 241b, and the second electrode pad 242 arranged in the emission areas.

The first stack ST1 may include a first n-type semiconductor layer NSML1, a first p-type semiconductor layer PSML1, and a first active layer MQW1 between the first n-type semiconductor layer NSML1 and the first p-type semiconductor layer PSML1.

The first n-type semiconductor layer NSML1 may overlap the first electrode pads 241g, 241r, and 241b, and the second electrode pad 242. The first n-type semiconductor layer NSML1 may include an n-type semiconductor layer, for example, a semiconductor material having a composition formula InₓAl_{y}Ga_{1-x-y}N (0≤x≤1, 0≤y≤1, 0≤x+y≤1). In an embodiment, for example, the first n-type semiconductor layer NSML1 may include at least one selected from GaN, AIN, AlGaN, InGaN, InN, InAlGaN, and AlInN doped with n-type dopants. The n-type dopant may include Si, Ge, and/or Sn. In an embodiment, the first n-type semiconductor layer NSML1 may include n-GaN doped with Si.

The first p-type semiconductor layer PSML1 may include a p-type semiconductor layer, for example, a semiconductor material having a composition formula InₓAl_{y}Ga_{1x-y}N (0≤x≤1, 0≤y≤1, 0≤x+y≤1). In an embodiment, for example, the first p-type semiconductor layer PSML1 may include at least one selected from GaN, AIN, AlGaN, InGaN, InN, InAlGaN, and AllnN doped with p-type dopants. The p-type dopant may include Mg, Zn, Ca, Se, and/or Ba. In an embodiment, the first p-type semiconductor layer PSML1 may include p-GaN doped with Mg.

The first p-type semiconductor layer PSML1 may include a plurality of portions apart from each other. In an embodiment, for example, the first p-type semiconductor layer PSML1 may include a first first p-type semiconductor portion PSML1-1 corresponding to a green emission area, a second first p-type semiconductor portion PSML1-2 corresponding to a red emission area, and a third first p-type semiconductor portion PSML1-3 corresponding to a blue emission area. The first first p-type semiconductor portion PSML1-1 may overlap the first first electrode pad 241g, the second first p-type semiconductor portion PSML1-2 may overlap the second first electrode pad 241r, and the third first p-type semiconductor portion PSML1-3 may overlap the third first electrode pad 241b.

The first active layer MQW1 may have a quantum well structure, for example, a multi-quantum well structure. In an embodiment, the first active layer MQW1 may include a multi-layered structure in which a well layer and a barrier layer are alternately stacked. In an embodiment, for example, the well layer may include InGaN, and the barrier layer may include GaN or AlGaN. The thickness of the well layer may be different from the thickness of the barrier layer. In another embodiment, the first active layer MQW1 may include a multi-layered structure in which a layer including a semiconductor material that has a large band gap energy, and a layer including a semiconductor material that has a small band gap energy are alternately stacked.

The first active layer MQW1 may include a plurality of portions apart from each other. In an embodiment, for example, the first active layer MQW1 may include a first first active portion MQW1-1 corresponding to a green emission area, a second first active portion MQW1-2 corresponding to a red emission area, and a third first active portion MQW1-3 corresponding to a blue emission area. The first first active portion MQW1-1 may overlap the first first electrode pad 241g, the second first active portion MQW1-2 may overlap the second first electrode pad 241r, and third first active portion MQW1-3 may overlap the third first electrode pad 241b.

The second first active portion MQW1-2 may be configured to emit light due to combining of electron-hole pairs in response to an electrical signal applied through the first n-type semiconductor layer NSML1 and the second first p-type semiconductor portion PSML1-2. In an embodiment, for example, the second first active portion MQW1-2 may be configured to emit blue light.

The third first active portion MQW1-3 may be configured to emit light due to combining of electron-hole pairs in response to an electrical signal applied through the first n-type semiconductor layer NSML1 and the third first p-type semiconductor portion PSML1-3. In an embodiment, for example, the third first active portion MQW1-3 may be configured to emit blue light.

The first n-type semiconductor layer NSML1 and a second n-type semiconductor layer NSML2 respectively disposed on two opposite sides of the first first active portion MQW1-1 with the first first active portion MQW1-1 therebetween may be electrically connected to each other. In an embodiment, for example, a conductor 260 electrically connects (e.g., short-circuit) the first n-type semiconductor layer NSML1 of the first stack ST1 to the second n-type semiconductor layer NSML2 of the second stack ST2, and thus, electron-hole pairs are not caused in the first first active portion MQW1-1. The first first active portion MQW1-1 corresponds to a kind of dummy active layer from which light is not emitted.

In an embodiment, as shown in FIG. 9, the conductor 260 extends along the lateral surface of the first first active portion MQW1-1. One end of the conductor 260 may be in contact with the first n-type semiconductor layer NSML1, and an opposing end of the conductor 260 may be in contact with the second n-type semiconductor layer NSML2. The conductor 260 may include a conductive material, for example, a metal.

The second stack ST2 may overlap the first stack ST1 and be arranged to correspond to one of the emission areas, for example, a green emission area. The second stack ST2 may be arranged to overlap the first first electrode pad 241g.

The second stack ST2 may include a second n-type semiconductor layer NSML2, a second p-type semiconductor layer PSML2, and a second active layer MQW2 between the second n-type semiconductor layer NSML2 and the second p-type semiconductor layer PSML2.

The second n-type semiconductor layer NSML2 may overlap the first first electrode pad 241g. The second n-type semiconductor layer NSML2 may include an n-type semiconductor layer, for example, a semiconductor material having a composition formula InₓAl_{y}Ga_{1-x-y}N (0≤x≤1, 0≤y≤1, 0≤x+y≤1). In an embodiment, for example, the second n-type semiconductor layer NSML2 may include at least one selected from GaN, AIN, AlGaN, InGaN, InN, InAlGaN, and AlInN doped with n-type dopants. The n-type dopant may include Si, Ge, and/or Sn. In an embodiment, the second n-type semiconductor layer NSML2 may include n-GaN doped with Si.

The second p-type semiconductor layer PSML2 may include a p-type semiconductor layer, for example, a semiconductor material having a composition formula InₓAl_{y}Ga_{1-x-y}N (0≤x≤1, 0≤y≤1, 0≤x+y≤1). In an embodiment, for example, the second p-type semiconductor layer PSML2 may include at least one selected from GaN, AIN, AlGaN, InGaN, InN, InAlGaN, and AlInN doped with p-type dopants. The p-type dopant may include Mg, Zn, Ca, Se, and/or Ba. In an embodiment, the second p-type semiconductor layer PSML2 may include p-GaN doped with Mg.

The second active layer MQW2 may be configured to emit light due to combining of electron-hole pairs in response to an electrical signal applied through the second n-type semiconductor layer NSML2 and the second p-type semiconductor portion PSML2. In an embodiment, for example, the second active layer MQW2 may be configured to emit light of a color, for example, green light different from a color of the first active layer MQW1.

The second active layer MQW2 may have a quantum well structure, for example, a multi-quantum well structure. In an embodiment, the second active layer MQW2 may include a multi-layered structure in which a well layer and a barrier layer are alternately stacked. In an embodiment, for example, the well layer may include InGaN, and the barrier layer may include GaN or AlGaN. The thickness of the well layer may be different from the thickness of the barrier layer. In an embodiment, the first active layer MQW1 and the second active layer MQW2 may include InGaN and have different contents of In. In another embodiment, the second active layer MQW2 may include a multi-layered structure in which a layer including a semiconductor material that has a large band gap energy, and a layer including a semiconductor material that has a small band gap energy are alternately stacked.

In a region overlapping the first first electrode pad 241g, for example, a green emission area, the second active layer MQW2 and the first first active portion MQW1-1 overlap each other, but light is not emitted from the first first active portion MQW1-1 due to the conductor 260. Because the first n-type semiconductor layer NSML1 of the first stack ST1 is electrically connected to the second n-type semiconductor layer NSML2 of the second stack ST2 by the conductor 260, electrons may be transferred from the first n-type semiconductor layer NSML1 to the second n-type semiconductor layer NSML2 through the conductor 260. Accordingly, light is not emitted from the first first active portion MQW1-1, and green light may be emitted due to combining of electron-hole pairs in the second active layer MQW2.

One surface of a stack structure of the first stack ST1 and the second stack ST2 may be protected by a first passivation layer PAS1. The first passivation layer PAS1 may include an inorganic insulating material such as silicon oxide, silicon nitride, and silicon oxynitride.

In the green emission area, a first first electrode 235-1 may be disposed between the second stack ST2 and the first first electrode pad 241g. In an embodiment, for example, the first first electrode layer 235-1 may be disposed between the second p-type semiconductor layer PSML2 and the first first electrode pad 241g and may electrically connect the second p-type semiconductor layer PSML2 to the first first electrode pad 241g.

In a red emission area, a second first electrode 235-2 may be disposed between the second first p-type semiconductor portion PSML1-2 and the second first electrode pad 241r. In a blue emission area, a third first electrode 235-3 may be disposed between the third first p-type semiconductor portion PSML1-3 and the third first electrode pad 241b. The first first electrode 235-1, the second first electrode 235-2, and the third first electrode 235-3 may include a conductive metal such as gold, copper, tin, titanium, aluminum, silver, and/or an alloy thereof.

A second electrode 238 may be disposed between the second electrode pad 242 and the first n-type semiconductor layer NSML1. The second electrode 238 may electrically connect the second electrode pad 242 to the first n-type semiconductor layer NSML1. The second electrode 238 may include a conductive metal, such as gold, copper, tin, titanium, aluminum, silver, or an alloy thereof.

Porous semiconductor layers may be disposed on each of the emission layers. In an embodiment, for example, in the red emission area, the first porous semiconductor layer 251 may overlap a portion of the first n-type semiconductor layer NSML1, the second first active portion MQW1-2, and the second first p-type semiconductor portion PSML1-2. In an embodiment, quantum dots may be disposed inside the first porous semiconductor layer 251, where the quantum dots are configured to convert light (e.g., blue light) emitted from the second first active portion MQW1-2 into light of a different color (e.g., red light). In an embodiment, quantum dots may be disposed inside a porous structure of the first porous semiconductor layer 251.

A second porous semiconductor layer 252 may be arranged in the green emission area, and a third porous semiconductor layer 253 may be arranged in the blue emission area. The second porous semiconductor layer 252 may overlap the second stack ST2, a portion of the first n-type semiconductor layer NSML1, the second first active portion MQW1-2, and the second first p-type semiconductor portion PSML1-2. The third porous semiconductor layer 253 may overlap a portion of the first n-type semiconductor layer NSML1, the third first active portion MQW1-3, and the third first p-type semiconductor portion PSML1-3. The second porous semiconductor layer 252 and the third porous semiconductor layer 253 do not include quantum dots.

Green light emitted from the second active layer MQW2 may pass through the second porous semiconductor layer 252 and be emitted to the outside. Because the second porous semiconductor layer 252 includes a porous structure, green light may be scattered to improve a light emission efficiency to the outside. According to an embodiment, because the second porous semiconductor layer 252 may not include quantum dots that are relatively vulnerable to oxidation, for example, may not include quantum dots configured to convert incident light into green light, deterioration of a light emission efficiency in the green emission area due to the quantum dots may be effectively prevented.

Blue light emitted from the third first active portion MQW1-3 may pass through the third porous semiconductor layer 253 and be emitted to the outside. Because the third porous semiconductor layer 253 includes a porous structure, blue light may be scattered to improve a light emission efficiency to the outside.

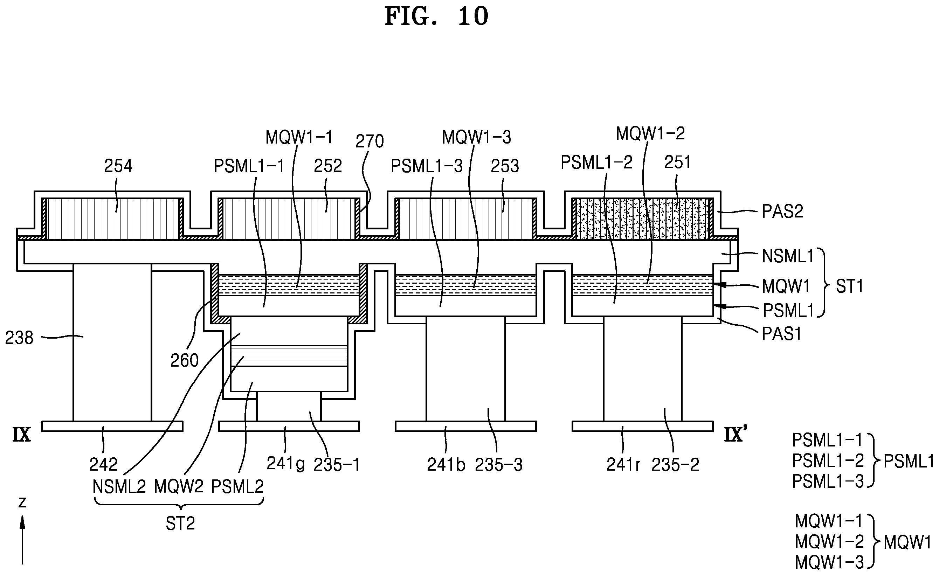

In an embodiment, as shown in FIG. 10, a fourth porous semiconductor layer 254 may be disposed on a portion of the first n-type semiconductor layer NSML1 to overlap the second electrode pad 242, but not being limited thereto. In another embodiment, the fourth porous semiconductor layer 254 may be omitted.

The first porous semiconductor layer 251, the second porous semiconductor layer 252, the third porous semiconductor layer 253, and the fourth porous semiconductor layer 254 may be protected by a second passivation layer PAS2. The second passivation layer PAS2 may include an inorganic insulating material such as silicon oxide, silicon nitride, and silicon oxynitride.

FIG. 10 is a cross-sectional view of the light-emitting element shown in FIG. 8A, taken along line IX-IX' of FIG. 8A according to an embodiment.

The light-emitting element 2300 of FIG. 10 includes a same structure as that of the light-emitting element of FIG. 9 except that the light-emitting element 2300 of FIG. 10 further includes a reflective layer 270. In the light-emitting element 2300 of FIG. 10, any repetitive detailed description of the same structure as those in FIG. 9 will be omitted, and description below focuses on the reflective layer 270.

In such an embodiment, the reflective layer 270 may be disposed on the lateral surface of at least selected from of the first porous semiconductor layer 251, the second porous semiconductor layer 252, and the third porous semiconductor layer 253. In an embodiment, as shown in FIG. 10, the reflective layer 270 is disposed on the lateral surface of each of the first porous semiconductor layer 251, the second porous semiconductor layer 252, and the third porous semiconductor layer 253.

Light emitted from each emission area may pass through the first porous semiconductor layer 251, the second porous semiconductor layer 252, and the third porous semiconductor layer 253, and be reflected by the reflective layer 270 to improve a light emission efficiency. The reflective layer 270 may include a metal.

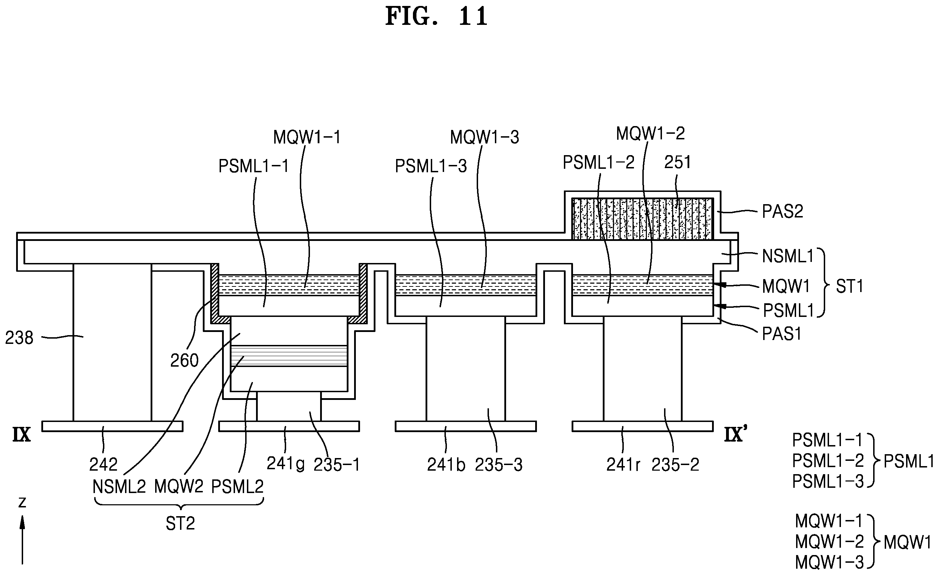

FIG. 11 is a cross-sectional view of the light-emitting element shown in FIG. 8A, taken along line IX-IX' of FIG. 8A according to an embodiment.

In an embodiment, as described above with reference to FIG. 9, the light-emitting element 2300 may include the first porous semiconductor layer 251, the second porous semiconductor layer 252, the third porous semiconductor layer 253, and the fourth porous semiconductor layer 254. In another embodiment, as shown in FIG. 11, the light-emitting element 2300 may include the first porous semiconductor layer 251 and may not include the second porous semiconductor layer 252, the third porous semiconductor layer 253, and the fourth porous semiconductor layer 254.

Because the structures of other elements of the light-emitting element 2300 of FIG. 11 are the same as those described above with reference to FIG. 9 except for the second porous semiconductor layer 252, the third porous semiconductor layer 253, and the fourth porous semiconductor layer 254, any repetitive detailed descriptions of the same or like elements as those described above will be omitted.

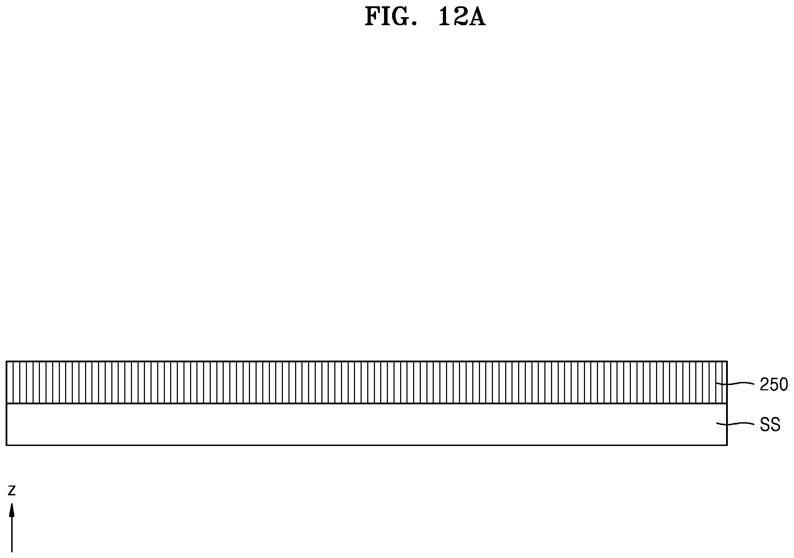

FIGS. 12A to 12H are cross-sectional views showing a process of manufacturing a display element, according to an embodiment.

Referring to FIG. 12A, in an embodiment of a process (or method) of manufacturing a display element, a porous semiconductor layer 250 is formed on a temporary substrate SS. In an embodiment, a process of forming the porous semiconductor layer 250 may include a process of forming an n-GaN layer on the temporary substrate SS using epitaxial growth, and a process of forming a porous structure using electrochemical etching.

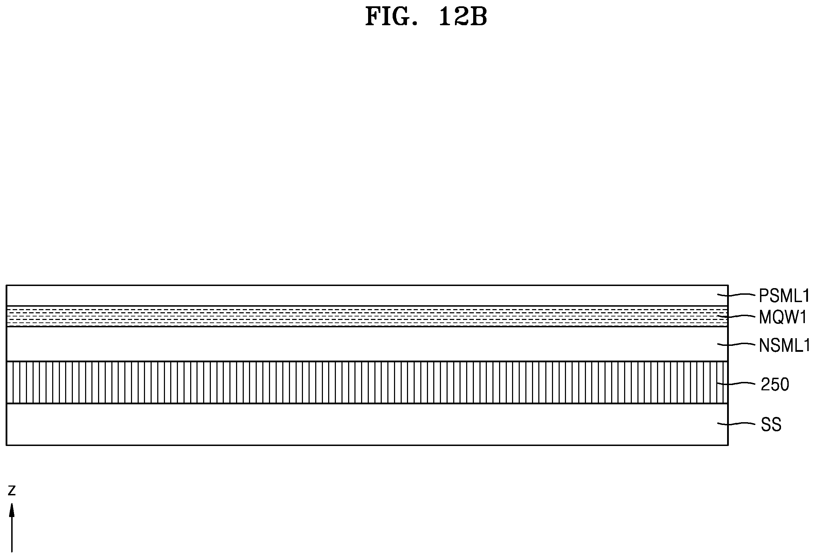

Referring to FIG. 12B, the first n-type semiconductor layer NSML1 may be formed on the porous semiconductor layer 250. Then, the first active layer MQW1 may be formed on the first n-type semiconductor layer NSML1, and the first p-type semiconductor layer PSML1 may be formed on the first active layer MQW1. The materials or structures of the first n-type semiconductor layer NSML1, the first active layer MQW1, and the first p-type semiconductor layer PSML1 are the same as those described above with reference to FIG. 9.

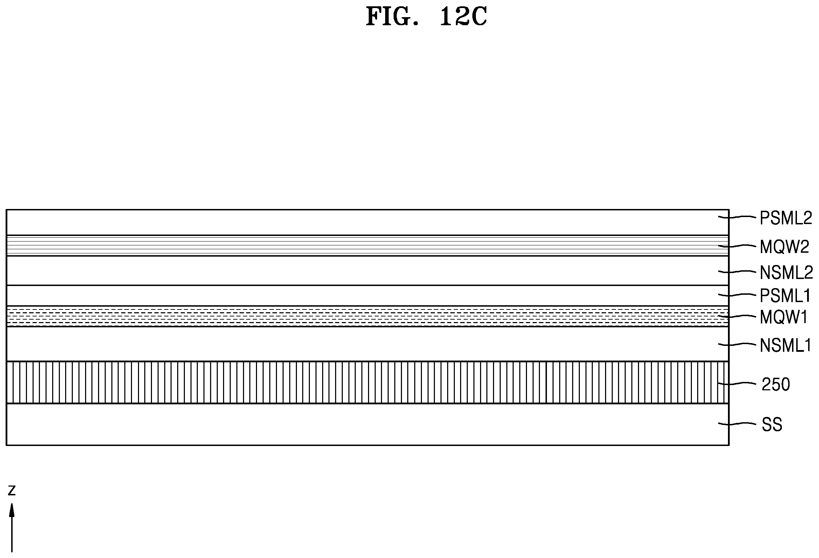

Referring to FIG. 12C, the second n-type semiconductor layer NSML2, the second active layer MQW2, and the second p-type semiconductor layer PSML2 may be sequentially formed on the structure of FIG. 12B. The materials or structures of the second n-type semiconductor layer NSML2, the second active layer MQW2, and the second p-type semiconductor layer PSML2 are the same as those described above with reference to FIG. 9.

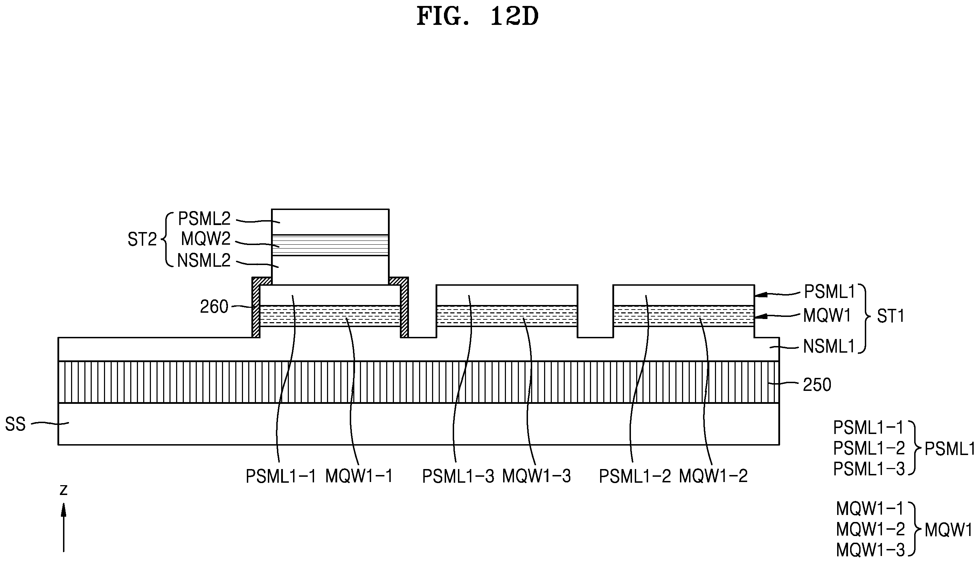

Referring to FIG. 12D, the second n-type semiconductor layer NSML2, the second active layer MQW2, and the second p-type semiconductor layer PSML2 are left in only one emission area (e.g., the green emission area) and the rest is removed by mesa etching the structure of FIG. 12C. In other words, the second stack ST2 including the second n-type semiconductor layer NSML2, the second active layer MQW2, and the second p-type semiconductor layer PSML2 may remain in only one emission area (e.g., the green emission area).

During the etching process, a portion of the first stack ST1 may be removed in a thickness direction or a depth direction (e.g., -z direction). Accordingly, the first p-type semiconductor layer PSML1 may include the first first p-type semiconductor portion PSML1-1, the second first p-type semiconductor portion PSML1-2, and the third first p-type semiconductor portion PSML1-3 separated from each other. The first active layer MQW1 may include the first first active portion MQW1-1, the second first active portion MQW1-2, and the third first active portion MQW1-3 separated from each other.

Then, the conductor 260 is formed. The conductor 260 extends along the lateral surface of the first first active portion MQW1-1. One end of the conductor 260 may be in contact with the first n-type semiconductor layer NSML1, and the other end of the conductor 260 may be in contact with the second n-type semiconductor layer NSML2. The conductor 260 may include a conductive material, for example, metal. The first n-type semiconductor layer NSML1 of the first stack ST1 may be electrically connected (e.g., short-circuited) to the second n-type semiconductor layer NSML2 by the conductor 260.

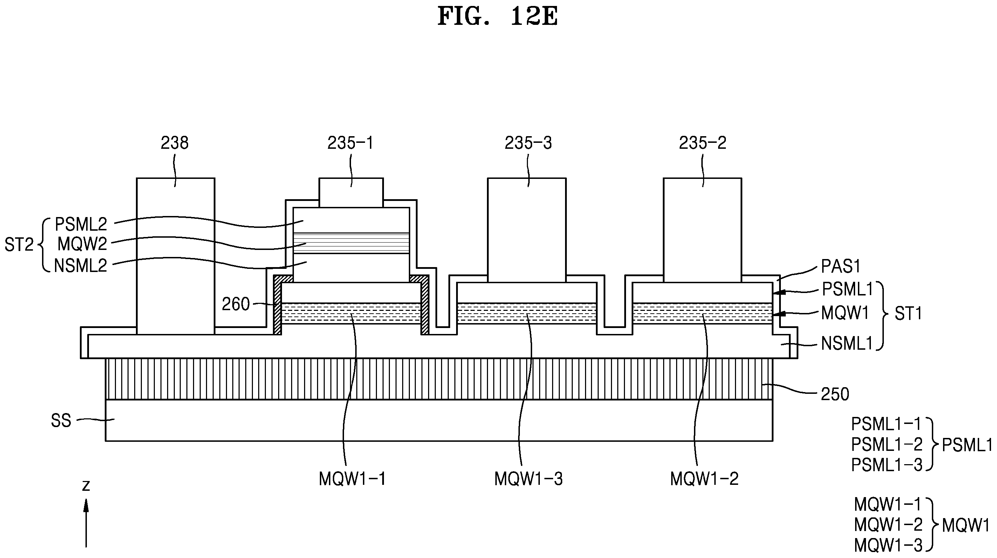

Referring to FIG. 12E, the first first electrode 235-1, the second first electrode 235-2, the third first electrode 235-3, and the second electrode 238 may be formed. Before the first first electrode 235-1, the second first electrode 235-2, the third first electrode 235-3, and the second electrode 238 are formed, the first passivation layer PAS1 may be formed. Then, the first first electrode 235-1, the second first electrode 235-2, the third first electrode 235-3, and the second electrode 238 may be respectively electrically connected to the second p-type semiconductor layer PSML2, the second first p-type semiconductor portion PSML1-2, the third first p-type semiconductor portion PSML1-3, and the first n-type semiconductor layer NSML1. The first first electrode 235-1, the second first electrode 235-2, the third first electrode 235-3, and the second electrode 238 may be respectively in direct contact with the second p-type semiconductor layer PSML2, the second first p-type semiconductor portion PSML1-2, the third first p-type semiconductor portion PSML1-3, and the first n-type semiconductor layer NSML1.

The first first electrode 235-1, the second first electrode 235-2, the third first electrode 235-3, and the second electrode 238 may include a conductive metal such as gold, copper, tin, titanium, aluminum, silver, or an alloy thereof.

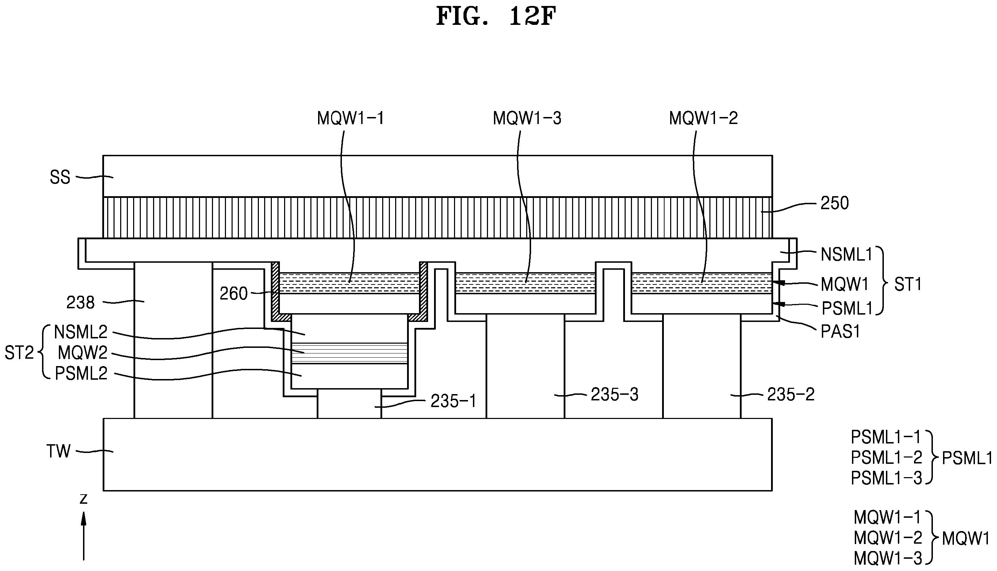

Referring to FIG. 12F, the structure of FIG. 12E is bonded to a carrier substrate TW. The first first electrode 235-1, the second first electrode 235-2, the third first electrode 235-3, and the second electrode 238 may be disposed on the upper surface of the carrier substrate TW. Then, the temporary substrate SS is removed.

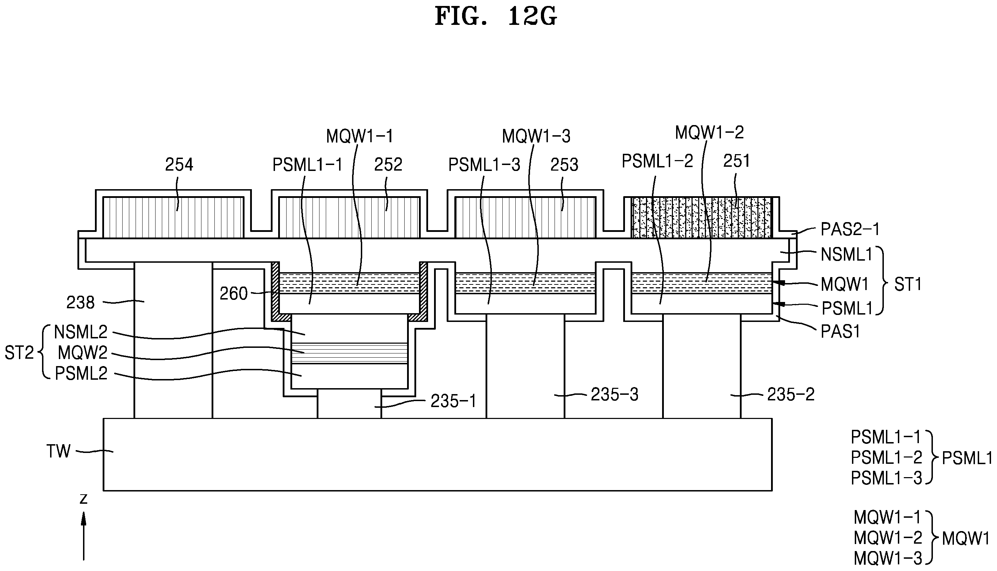

Referring to FIG. 12G, by removing a portion of the porous semiconductor layer 250 (see FIG. 12F), the first porous semiconductor layer 251, the second porous semiconductor layer 252, the third porous semiconductor layer 253, and the fourth porous semiconductor layer 254 are formed. Then, a first passivation is performed. A first second passivation layer PAS2-1 may be formed to cover the first porous semiconductor layer 251, the second porous semiconductor layer 252, the third porous semiconductor layer 253, and the fourth porous semiconductor layer 254. The first second passivation layer PAS2-1 may include an inorganic insulating material such as silicon oxide, silicon nitride, and silicon oxynitride.

Next, a portion of the first second passivation layer PAS2-1 present on the first porous semiconductor layer 251 is removed, and quantum dots, for example, quantum dots configured to convert incident light (blue light) into red light are injected to a porous structure of the first porous semiconductor layer 251.

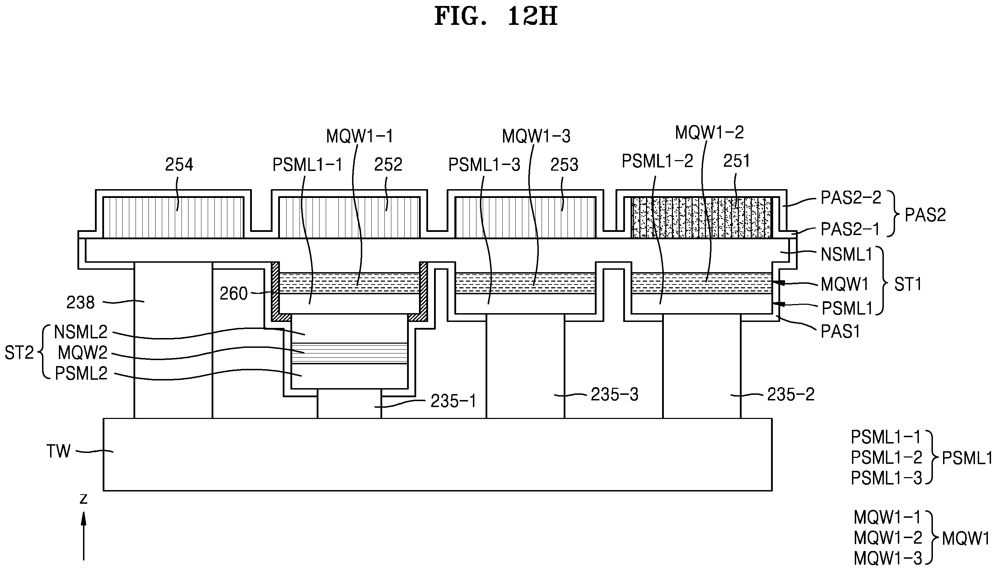

Then, as illustrated in FIG. 12H, the upper surface of the first porous semiconductor layer 251 may be covered by a second second passivation layer PAS2-2. The second second passivation layer PAS2-2 may include a material same as or different from a material of the first second passivation layer PAS2-1. The second second passivation layer PAS2-2 may include an inorganic insulating material such as silicon oxide, silicon nitride, or silicon oxynitride. The first second passivation layer PAS2-1 and the second second passivation layer PAS2-2 may correspond to the second passivation layer PAS2 described above with reference to FIG. 9.

The light-emitting element 2300 separated from the carrier substrate TW may be disposed on the first electrode pads 241g, 241r, and 241b, and the second electrode pad 242 to be electrically connected to the first electrode pads 241g, 241r, and 241b, and the second electrode pad 242 as shown in FIGS. 8A and 8B.

The display device according to embodiments may be used in various electronic apparatuses capable of displaying images. Here, the electronic apparatuses denote apparatuses that use electricity and may display preset images.

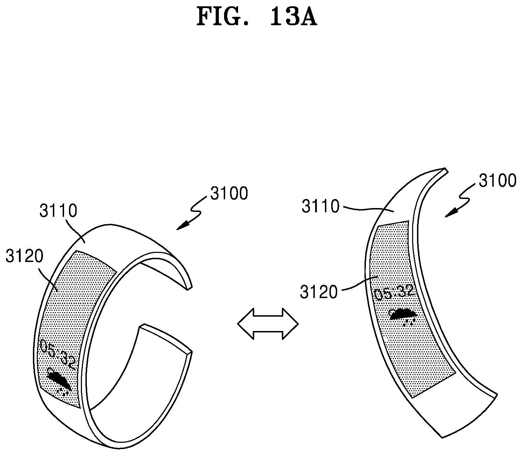

FIGS. 13A to 13G are each schematic perspective views of embodiments of an electronic apparatus including the display device according to an embodiment.

Referring to FIG. 13A, the display device according to an embodiment may be utilized in a wearable electronic apparatus 3100 that may be worn on a portion of a user's body. The wearable electronic apparatus 3100 may include a body portion 3110 and a display 3120 provided to the body portion 3110. The display device according to embodiments may be used as the display 3120 of the wearable electronic apparatus 3100. In an embodiment, as shown in FIG. 13A, the wearable electronic apparatus 3100 may be transformed. In an embodiment, the wearable electronic apparatus 3100 may be used as a smartwatch or a smartphone depending on a user's selection.

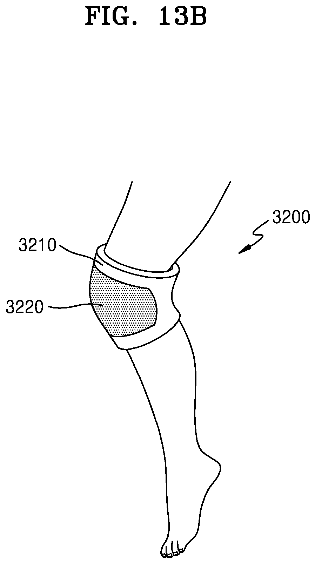

FIG. 13B shows an embodiment where the electronic apparatus is a medical electronic apparatus 3200. In an embodiment, the medical electronic apparatus 3200 may include a body portion 3210 and an emission portion 3220. The display device according to embodiments may be used as the emission portion 3220 of the medical electronic apparatus 3200. The emission portion 3220 may be configured to emit light in a preset wavelength band (e.g., an infrared ray, a visible ray, and the like) to a patient's body. In an embodiment, the body portion 3210 may include a stretchable fiber material and may have a structure that may be worn on the body of the user who uses the emission portion.

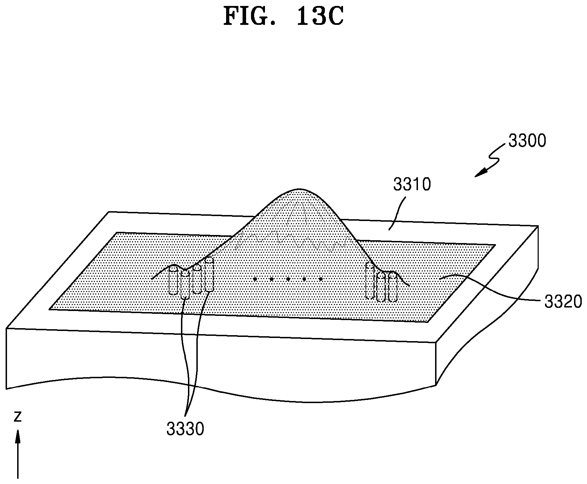

FIG. 13C shows an embodiment where the electronic apparatus is an educational electronic apparatus 3300. In an embodiment, the educational electronic apparatus 3300 may include a display 3320 provided inside a frame 3310. The display 3320 may correspond to the display device according to embodiments described above. Images such as sea with waves, a mountain covered with snow, or a volcano with flowing lava may be provided through the display 3320, and in this case, the display 3320 may extend in the height direction (e.g., a z direction) to reflect the height of waves, mountains, or volcanoes. In an embodiment, because a portion of the display 3320 may show the movements of lava three dimensionally by sequentially changing its height in a direction in which the lava flows. The educational electronic apparatus 3300 may include a plurality of pins 3330 (or stroke portions) disposed on the backside of the display 3320 such that the display 3320 extends in a height direction. As the pins 3330 move in the third direction (e.g., a z direction or a -z direction), the image displayed on the display 3320 may be implemented to have a three-dimensional height. Although FIG. 13C shows embodiment where the electronic apparatus is the educational electronic apparatus 3300, the purpose of the electronic apparatus is not limited as long as the electronic apparatus provides preset image information.

Although embodiments of the electronic apparatuses shown in FIGS. 13A to 13C are electronic apparatuses whose shapes are variable, the embodiment is not limited thereto. In other embodiments, as described below, the display device may be used in an electronic apparatus in which a portion (e.g., a screen) capable of displaying images is fixed.

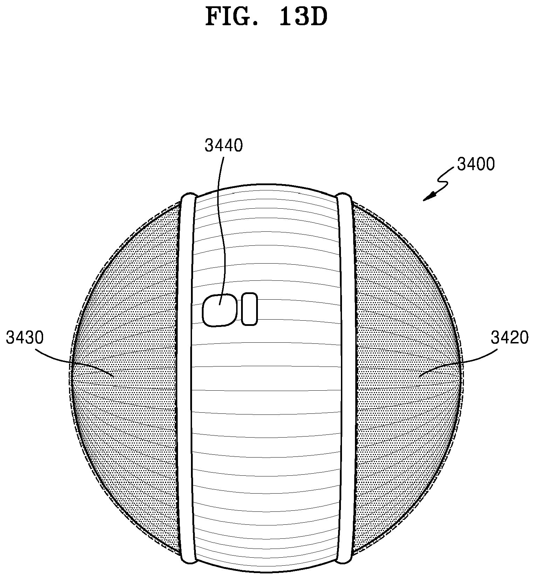

FIG. 13D shows an embodiment where the electronic apparatus is a robot 3400. The robot 3400 may move or recognize an object by using a camera portion 3440 and display preset images to a user through displays 3420 and 3430. In an embodiment, because the display devices according to an embodiment may be stretched in various directions as described above, the display devices may be assembled to a body frame having a hemispherical shape, and thus, the robot 3400 may include the displays 3420 and 3430 having a hemispherical shape.

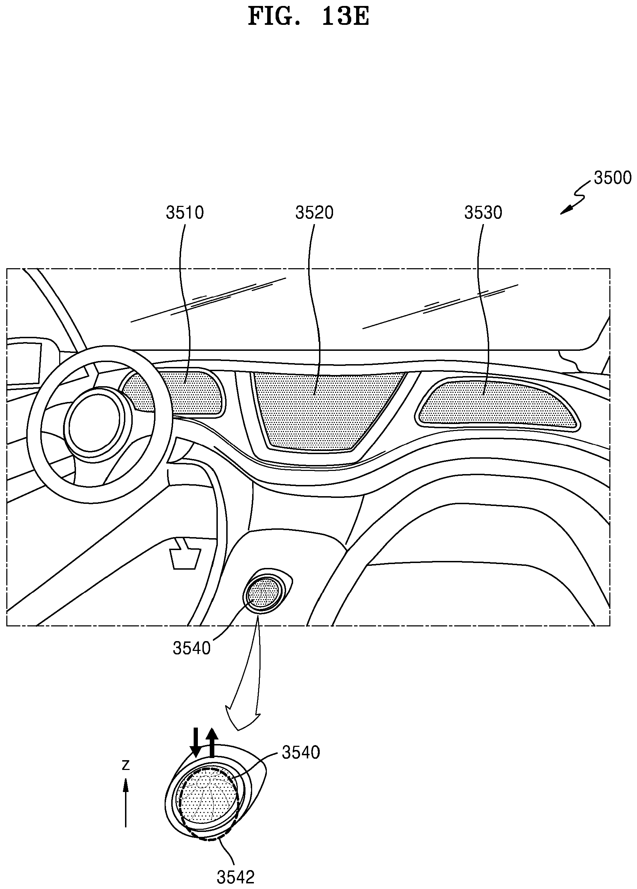

FIG. 13E shows an embodiment where the electronic apparatus is a vehicle display device 3500. The vehicle display device 3500 may include a cluster 3510, a center information display (CID) 3520, and/or a passenger display. Because the display device according to an embodiment may be stretched in various directions, the display device may be used as the cluster 3510, the CID 3520, and/or a co-driver display regardless of the shape of an internal frame of the vehicle.

In an embodiment, as shown in FIG. 13E, the cluster 3510, the CID 3520, and/or the co-driver display are separated from each other, but the embodiment is not limited thereto. In another embodiment, two or more of the cluster 3510, the CID 3520, and/or the co-driver display may be integrally connected.

In an embodiment, the vehicle display device 3500 may include a button 3540 that may display preset images. Referring to an enlarged view of FIG. 13E, the button 3540 having a hemispherical shape may include an object 3542 that provides the feeling of using the button while moving in the z direction or -z direction, and a display device disposed on the object 3542. In an embodiment, in the case where the object 3542 has a surface rounded three-dimensionally, the display device may also have a surface rounded three-dimensionally.

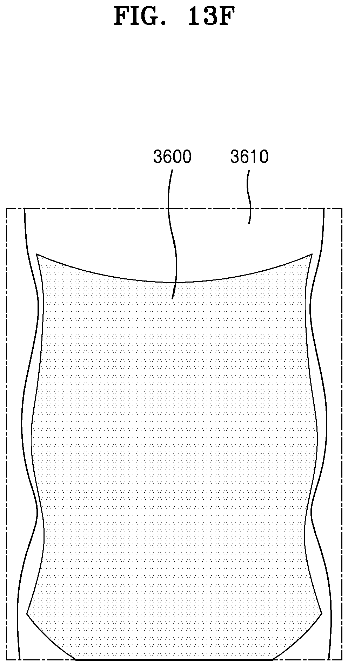

FIG. 13F shows an embodiment where the electronic apparatus is an electronic apparatus 3600 for advertising or exhibition. In an embodiment, the electronic apparatus 3600 for advertising or exhibition may be installed at a structure 3610 such as a wall or pillar. In the case where the structure 3610 includes an uneven surface as shown in FIG. 13F, the electronic apparatus 3600 for advertising or exhibition may be also disposed along the uneven surface of the structure 3610. In an embodiment, the electronic apparatus 3600 for advertising or exhibition may be installed at the structure 3610 using a heat shrink film and the like.

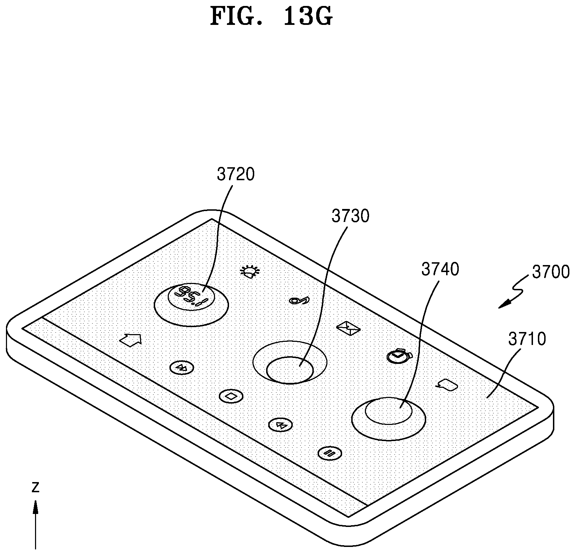

FIG. 13G shows an embodiment where the electronic apparatus is a controller 3700. The controller 3700 may include an image type button. In an embodiment, for example, the controller 3700 may include first to third bottom regions 3720, 3730, and 3740 in which a partial region of a display 3710 protrudes in a z direction or -z direction (or collapses in the z direction). In an embodiment, the first and third button regions 3720 and 3740 may protrude in the z direction, and the second button region 3730 may protrude in the -z direction (or collapse in the z direction).

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the spirit or scope of the invention as defined by the claims.

## Claims

1. A display device comprising:
a plurality of first electrode pads respectively corresponding to a plurality of emission areas which emit light of different colors, respectively;
a second electrode pad disposed in a same layer as the plurality of first electrode pads; and
a light-emitting element electrically connected to the plurality of first electrode pads and the second electrode pad,
wherein the light-emitting element includes:
a first stack including a first n-type semiconductor layer, a first p-type semiconductor layer, and a first active layer between the first n-type semiconductor layer and the first p-type semiconductor layer;
a second stack overlapping the first stack in a first emission area among the plurality of emission areas, and including a second n-type semiconductor layer, a second p-type semiconductor layer, and a second active layer between the second n-type semiconductor layer and the second p-type semiconductor layer; and
a conductor electrically connecting the first n-type semiconductor layer of the first stack to the second n-type semiconductor layer of the second stack.

2. The display device of claim 1, wherein the second active layer emits green light.

3. The display device of claim 1, wherein
the first stack of the light-emitting element extends to a second emission area different from the first emission area, and
the first active layer of the first stack includes a first first active portion arranged in the first emission area, and
a second first active portion separated from the first first active portion and arranged in the second emission area, and
the light-emitting element further includes:
a first porous semiconductor layer overlapping the first stack in the second emission area; and
a plurality of quantum dots disposed inside the first porous semiconductor layer.

4. The display device of claim 3, wherein the plurality of quantum dots convert light emitted from the second first active portion into light of a different color.

5. The display device of claim 3, wherein the second first active portion emits blue light.

6. The display device of claim 3, further comprising:
a reflective layer disposed on a lateral surface of the first porous semiconductor layer.

7. The display device of claim 1, further comprising:
a second porous semiconductor layer overlapping the first stack and the second stack in the first emission area.

8. The display device of claim 7, wherein the second porous semiconductor layer does not include quantum dots.

9. The display device of claim 1, wherein the first n-type semiconductor layer of the first stack extends to overlap the second electrode pad, and
the display device further comprises an electrode disposed between the first n-type semiconductor layer and the second electrode pad, and electrically connecting the first n-type semiconductor layer to the second electrode pad.

10. A display device comprising:
a plurality of first electrode pads respectively corresponding to a first emission area, a second emission area, and a third emission area;
a second electrode pad arranged to be adjacent to the plurality of first electrode pads; and
a light-emitting element electrically connected to the plurality of first electrode pads and the second electrode pad,
wherein the light-emitting element includes:
a first stack including a first n-type semiconductor layer overlapping the plurality of first electrode pads, a first p-type semiconductor layer on the first n-type semiconductor layer, and a first active layer between the first n-type semiconductor layer and the first p-type semiconductor layer;
a second stack overlapping the first stack in the first emission area, and including a second n-type semiconductor layer, a second p-type semiconductor layer, and a second active layer between the second n-type semiconductor layer and the second p-type semiconductor layer; and
a conductor electrically connecting the first n-type semiconductor layer of the first stack to the second n-type semiconductor layer of the second stack, and
wherein the first active layer includes a first first active portion arranged in the first emission area, a second first active portion arranged in the second emission area, and a third first active portion arranged in the third emission area.

11. The display device of claim 10, wherein
the first first active portion is separated from the second first active portion and the third first active portion, and
the first first active portion does not emit light, and
the second first active portion emits blue light.

12. The display device of claim 11, wherein the second active layer emits green light.

13. The display device of claim 10, wherein the light-emitting element further includes:
a first porous semiconductor layer overlapping the first stack in the second emission area; and
a plurality of quantum dots disposed inside the first porous semiconductor layer, and
the plurality of quantum dots convert light emitted from the second first active portion into light of a different color.

14. The display device of claim 13, further comprising:
a reflective layer disposed on a lateral surface of the first porous semiconductor layer.

15. The display device of claim 10, wherein the first n-type semiconductor layer of the first stack extends to overlap the second electrode pad, and
the display device further comprises an electrode disposed between the first n-type semiconductor layer and the second electrode pad, and electrically connecting the first n-type semiconductor layer to the second electrode pad.

16. A display device including a display area and a non-display area outside the display area, the display device comprising:
a first island portion arranged in the display area;
a first bridge portion connecting the first island portion to another first island portion adjacent to the first island portion;
a plurality of first electrode pads respectively arranged in a plurality of emission areas disposed in the first island portion;
a second electrode pad arranged in the first island portion and adjacent to the plurality of first electrode pads; and
a light-emitting element electrically connected to the plurality of first electrode pads and the second electrode pad,
the light-emitting element includes:
a first stack including a first n-type semiconductor layer, a first p-type semiconductor layer, and a first active layer between the first n-type semiconductor layer and the first p-type semiconductor layer;
a second stack overlapping the first stack in a first emission area among the plurality of emission areas, and including a second n-type semiconductor layer, a second p-type semiconductor layer, and a second active layer between the second n-type semiconductor layer and the second p-type semiconductor layer; and
a conductor electrically connecting the first n-type semiconductor layer of the first stack to the second n-type semiconductor layer of the second stack.

17. The display device of claim 16, wherein
the first stack of the light-emitting element extends to a second emission area different from the first emission area,
the first active layer of the first stack includes a first first active portion arranged in the first emission area,
a second first active portion separated from the first first active portion and arranged in the second emission area,
the first first active portion does not emit light, and
the second first active portion emits blue light.

18. The display device of claim 17, wherein the second active layer emits green light.

19. The display device of claim 17, wherein the light-emitting element further includes:
a first porous semiconductor layer overlapping the first stack in the second emission area; and
a plurality of quantum dots disposed inside the first porous semiconductor layer.

20. The display device of claim 19, wherein the plurality of quantum dots convert light emitted from the second first active portion into light of a different color.

21. The display device of claim 19, further comprising:
a reflective layer disposed on a lateral surface of the first porous semiconductor layer.

22. The display device of claim 16, further comprising:
a second porous semiconductor layer overlapping the first stack and the second stack in the first emission area.

23. The display device of claim 22, wherein the second porous semiconductor layer does not include quantum dots.

24. The display device of claim 16, wherein the first n-type semiconductor layer of the first stack extends to overlap the second electrode pad, and
the display device further comprises an electrode disposed between the first n-type semiconductor layer and the second electrode pad, and electrically connecting the first n-type semiconductor layer to the second electrode pad.
